(19) Europäisches Patentamt
European Patent Office
Office européen des brevets

(11) **EP 1 367 732 B1**

(12) **EUROPEAN PATENT SPECIFICATION**

(45) Date of publication and mention
of the grant of the patent:
**04.04.2007 Bulletin 2007/14**

(51) Int Cl.:
*H03M 13/29* (2006.01)    *H03M 13/25* (2006.01)
*H03M 13/45* (2006.01)

(21) Application number: **03012460.6**

(22) Date of filing: **30.05.2003**

(54) **Soft-in soft-out decoder for turbo trellis coded modulation**

Soft-In Soft-Out Dekoder für Turbo-Trelliskodierte Modulation

Décodeur à entrées et sorties souples pour modulation en treillis turbo-codée

(84) Designated Contracting States:
**DE FR GB**

(30) Priority: **31.05.2002 US 384698 P**
**04.10.2002 US 264486**
**18.12.2002 US 434734 P**
**22.05.2003 US 444148 P**

(43) Date of publication of application:
**03.12.2003 Bulletin 2003/49**

(73) Proprietor: **Broadcom Corporation**
**Irvine, CA 92618-7013 (US)**

(72) Inventors:
• **Cameron, Kelly B.**
**92619-7013 Irvine, CA (US)**
• **Shen, Ba-Zhong**
**92619-7013 Irvine, CA (US)**
• **Tran, Hau Thien**
**92619-7013 Irvine, CA (US)**

(74) Representative: **Jehle, Volker Armin**
**Bosch, Graf von Stosch, Jehle,**
**Flüggenstrasse 13**
**80639 München (DE)**

(56) References cited:
**EP-A- 1 156 588**         **WO-A-02/23739**

• **RAOUAFI F ET AL: "Saving memory in turbo-decoders using the Max-Log-MAP algorithm" IEE COLLOQUIUM, TURBO CODES IN DIGITAL BROADCASTING - COULD IT BE DOUBLE CAPACITY, XX, XX, 22 November 1999 (1999-11-22), pages 14/1-14/4, XP002185687**
• **SCHURGERS C ET AL: "Optimized map turbo decoder" PROC. OF IEEE WORKSHOP ON SIGNAL PROCESSING SYSTEMS SIPS 2000, 11 October 2000 (2000-10-11), pages 245-254, XP010525234**
• **AKELLA R ET AL: "On the parallel map algorithm" PROC. OF IEEE WORKSHOP ON MULTIMEDIA SIGNAL PROCESSING, 3 October 2001 (2001-10-03), pages 371-376, XP010565802 CANNES, FRANCE**

**Description**

**BACKGROUND OF THE INVENTION**

**TECHNICAL FIELD OF THE INVENTION**

The invention relates generally to communication systems; and, more particularly, it relates to decoding of encoded signals within such communication systems.

**DESCRIPTION OF RELATED ART**

Data communication systems have been under continual development for many years. One such type of communication system that has been of significant interest lately is a communication system that employs turbo codes. Another type of communication system that has also received interest is a communication system that employs Low Density Parity Check (LDPC) code. A primary directive in these areas of development has been to try continually to lower the error floor within a communication system. The ideal goal has been to try to reach Shannon's limit in a communication channel. Shannon's limit may be viewed as being the data rate to be used in a communication channel, having a particular Signal to Noise Ratio (SNR), that achieves error free transmission through the communication channel. In other words, the Shannon limit is the theoretical bound for channel capacity for a given modulation and code rate.

LDPC code has been shown to provide for excellent decoding performance that can approach the Shannon limit in some cases. For example, some LDPC decoders have been shown to come within 0.3 dB from the theoretical Shannon limit. While this example was achieved using an irregular LDPC code of a length of one million, it nevertheless demonstrates the very promising application of LDPC codes within communication systems.

In performing calculations when decoding a received signal, it is common for decoders to perform determination of a largest (using a max calculation or a max operation) and/or a smallest (using a min calculation or a min operation) to determine a largest or smallest value from among a number of values. This processing is oftentimes common in performing calculations of state metrics within soft-in soft-out functional block (SISO) decoders. For example, several state metrics are calculated, and the smallest and/or largest state metric is determined to be the proper state metric. Depending upon the decision criteria, the largest and/or smallest state metric may be determined to be the "proper" state metric.

In performing calculations when decoding a received signal, it is also common for decoders to operate in the natural log (ln) domain when performing various calculations. Many turbo code decoders fall into this category, and many LDPC decoders also fall in to this category as well. By operating within the natural log (ln) domain, this converts all multiplications to additions, divisions to subtractions, and eliminates exponentials entirely, without affecting Bit Error Rate (BER) performance. While this approach represents one such way in which some of the difficult processing steps required to decode signals received within such communication systems, they are focused on addressing just one aspect of the decoding difficulties.

Another processing challenge in the decoding of such signals received within communication systems is the management of the very data itself. The memory management required to perform proper decoding of such signals can also be very burdensome. Oftentimes, in prior art systems, it is the management of the data within the decoding of received data that presents one of the largest bottlenecks in the system.

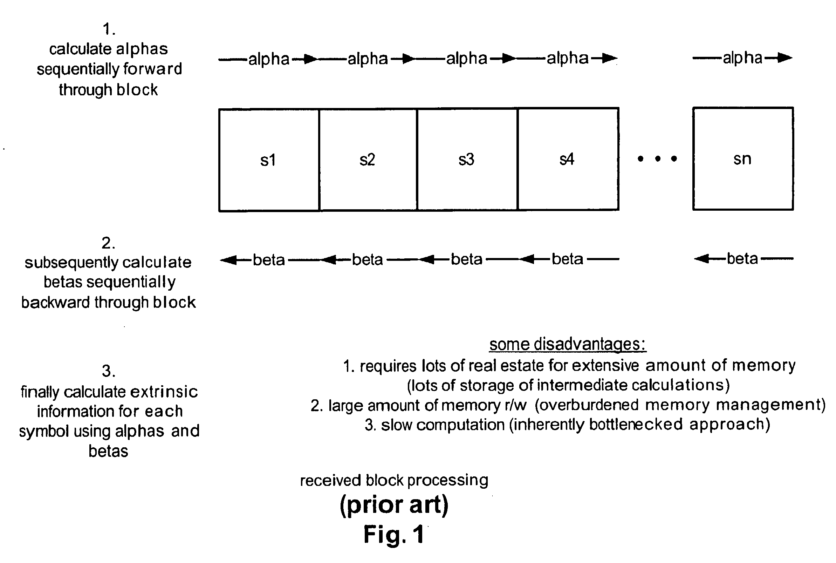

FIG. 1 is a diagram illustrating one prior art approach to received block processing. Initially, forward metrics (alphas) are sequentially calculated for each symbol within the received block in one direction. Then, backward metrics (betas) are sequentially calculated for each symbol within the received block in the opposite direction. After the alphas and betas have been determined for each symbol within the block, then extrinsic (ext) information may be calculated there from to proceed in the final decoding of the received symbols within the block. There are a number of apparent disadvantages to this prior art approach to received block processing. Some of the disadvantages include that it requires a lot of real estate to support the extensive memory that must be provisioned to enable such an approach. Within many communication systems, including those employing TCM, there are a number of intermediate calculations that must be performed (e.g., the alpha and beta calculations that precede the ext calculations) and these intermediate values must be stored for subsequent use in the prior art approach.

Another disadvantage, inherently coupled to the disadvantage of requiring a large amount of memory, is that there is a large amount of read/write (r/w) operations that must be performed to support this processing. The memory management performed herein is typically quite overburdened. In addition, the computation can be very slow, in that, a large number of intermediate calculations must be performed to support the decoding of data within this prior art approach. It is also noted that as the block size continues to increase, this prior art simply becomes more and more difficult to implement. It is clear that as the block size increases, the memory required, the r/with operations, and the memory required will be scaled accordingly.

There exists a need in the art to provide for a much more efficient approach to processing a received block of data that would address any of the deficiencies described above within the prior art approach of sequential processing to generate the necessary intermediate and final calculations required to decoded the received block. In addition, it would be desirable that such a design be scalable and able to accommodate larger and/or smaller blocks as implemented within various types of com systems.

EP 1 156 588 A1 relates to a maximum a posteriori probability decoding method and apparatus for calculating backward probability and then calculating forward probability in maximum a posteriori probability decoding, thereby reducing amount of memory used.

WO 02/23739 A2 describes a process and an apparatus for reducing memory requirements and increasing speed of decoding turbo encoded data in a MAP decoder. Turbo coded data is decoded by computing alpha values and saving checkpoint alpha values on a stack. The checkpoint values are then used to recreate the alpha values to be used in computations when needed. By saving only a subset of the alpha values memory to hold them is conserved.

According to the invention, there are provided a soft-in soft-out functional block as defined by independent claim 1 and a received block processing method as defined by independent claim 13.

Further advantageous features are defined in the dependent subclaims.

Various aspects of the invention can be found in any number of devices that perform processing and decoding of a received block of data. Certain aspects of the invention may also be found in the various function components of such a decoder that performs the decoding of the block. One functional component aspect of the invention is found in a soft-in soft-out functional block (SISO) that operates to calculate soft symbol decisions (that may itself including calculating one or more soft bit decisions) for a block that includes encoded symbols arranged into a plurality of sub-blocks. The SISO includes a first alpha/beta metric calculation functional block and a second alpha/beta metric calculation functional block.

The characteristics of the signal that is decoded using the invention may be variable in nature. This variability may come in the form of variable code rate, variable modulation type that may itself further vary having variable constellation type and variable mapping of the constellations employed therein. All of this variability may occur on a symbol by symbol basis within the signal that is to be decoded according to the invention. One manner to accommodate this variability is for the plurality of encoded symbols to be encoded according to a rate control sequence having a plurality of rate controls arranged in a period. One or more rate controls of the plurality of rate controls may include a modulation that includes a constellation having a mapping. Again, the variability may occur one a symbol by symbol basis such that a first rate control of the plurality of rate controls includes a first modulation that includes a first constellation having a first mapping, and such that a second rate control of the plurality of rate controls includes a second modulation that includes a second constellation having a second mapping.

**BRIEF DESCRIPTION OF THE SEVERAL VIEWS OF THE DRAWINGS**

FIG. 1 is a diagram illustrating one prior art approach to received block processing.
FIG. 2 is a system diagram illustrating an embodiment of a satellite communication system that is built according to the invention.
FIG. 3 is a system diagram illustrating an embodiment of a High Definition Television (HDTV) communication system that is built according to the invention.
FIG. 4A and FIG. 4B are system diagrams illustrating embodiments of uni-directional cellular communication systems that are built according to the invention.
FIG. 4C is a system diagram illustrating embodiment of a bi-directional cellular communication system that is built according to the invention.
FIG. 5A is a system diagram illustrating an embodiment of a uni-directional microwave communication system that is built according to the invention.
FIG. 5B is a system diagram illustrating an embodiment of a bi-directional microwave communication system that is built according to the invention.
FIG. 6A is a system diagram illustrating an embodiment of a uni-directional point-to-point radio communication system that is built according to the invention.
FIG. 6B is a system diagram illustrating an embodiment of a bi-directional point-to-point radio communication system that is built according to the invention.
FIG. 7A is a system diagram illustrating an embodiment of a uni-directional communication system that is built according to the invention.
FIG. 7B is a system diagram illustrating an embodiment of a bi-directional communication system that is built according to the invention.

FIG. 7C is a system diagram illustrating an embodiment of a one to many communication system that is built according to the invention.

FIG. 8 is a system diagram illustrating an embodiment of a fiber-optic communication system that is built according to the invention.

FIG. 9 is a system diagram illustrating an embodiment of a satellite receiver set-top box system that is built according to the invention.

FIG. 10 is a diagram illustrating an embodiment of a TTCM (Turbo Trellis Coded Modulation) decoder design that is built according to the invention.

FIG. 11 is a diagram illustrating in-phase and quadrature (I,Q) signal extraction that is performed according to the invention.

FIG. 12 is a diagram illustrating an alternative embodiment of a TTCM decoder design that is built according to the invention that recycles a single SISO (soft-in soft-out functional block).

FIG. 13 is a diagram illustrating an embodiment of received block processing that is performed according to the invention.

FIG. 14 is a diagram illustrating an embodiment of how symbols may be passed for metric calculation according to the invention (shown using an 8 symbol embodiment).

FIG. 15A is a diagram illustrating an embodiment of the order of output from a metric generator according to the invention (which is the same order of output from an interleaver/de-interleaver according to the invention).

FIG. 15B is a diagram illustrating an embodiment of the order of output from a SISO (soft-in soft-out functional block) according to the invention.

FIG. 16 is a diagram illustrating an embodiment of the final output of decoding that may be provided to make hard decisions according to the invention.

FIG. 17 is a diagram illustrating an embodiment of the last iteration of SISO processing according to the invention (shown in an embodiment using a recycled SISO).

FIG. 18 is a diagram illustrating an embodiment of SISO received block processing functionality that is supported according to the invention.

FIG. 19 is a diagram illustrating an embodiment of SISO functional block arrangement according to the invention.

FIG. 20 is a diagram illustrating an embodiment of address generation for an interleaver/de-interleaver functional block according to the invention.

FIG. 21 is a diagram illustrating an embodiment of a bit interleave/de-interleave functional block according to the invention.

FIG. 22 is a diagram illustrating an embodiment of counter usage within block processing according to the invention (shown in a 128 symbol sub-block embodiment).

FIG. 23 is a flowchart illustrating an embodiment of a received block processing method that is performed according to the invention.

## DETAILED DESCRIPTION OF THE INVENTION

The invention involves several aspects of a novel and very efficient decoder design that is, in one embodiment, tailored for use in decoding signals encoded using TTCM (Turbo Trellis Coded Modulation), PC-TCM (Parallel Concatenated Trellis Coded Modulation), and/or Trellis Code Modulation (TCM). The invention employs a design that is readily adaptable to support decoding of signals that may vary on a symbol by symbol basis of having variable code rates, variable modulation types, various constellation shapes and/or variable mappings for those constellation shapes as well. The invention performs intelligent reordering and manipulation of the individual symbols of a received block that allows for very fast processing as well as relatively minimal amounts of hardware required in the implementation (memory, registers, etc.).

Generally speaking, the invention processes a received block by initially performing symbol processing within the block to generate a number of check point values for selected sub-blocks. The processing begins calculation for forward metrics (alphas) beginning at one end of the block and working toward the block middle and backward metrics (betas) beginning at the other end of the block and working toward the block middle. The invention pushes check point values, associated with the sub-blocks onto a check point stack, in one embodiment. These check point values indicate the initial conditions that may be later used to re-calculate the appropriate alphas and betas, respectively, within these sub-blocks. Initially, only the check point values are stored during the initial processing that processed the block beginning from both ends and working towards the block middle. After reaching the sub-blocks adjacent to the block middle, the processing then calculates and stores each of the alphas for the sub-block on one side of the block middle and each of the betas for the sub-block on other side of the block middle. The storing of the alphas and betas may be performed using alpha/beta stacks according to the invention. Stacks may also be referred to as First In-Last Out (FILO) storage devices where elements are pushed and popped there from; the last element pushed (written/stored) onto the stack/FILO will then be first element popped (read/retrieved) there from.

After the processing reaches the block middle, the processing according to the invention is able to provide extrinsic information for each and every symbol successively beginning from the block middle and extending out towards the two block ends. The corresponding alpha that has been stored each symbol of the sub-block on the one side of the block middle, as described above in the initial processing, is retrieved as the corresponding beta for each respective symbol is calculated. The associated retrieved alpha and just calculated beta may then be used immediately to calculate the extrinsic information associated with each symbol within this sub-block. Similarly, the corresponding beta that has been stored each symbol of the sub-block on the other side of the block middle, as described above in the initial processing, is retrieved as the corresponding alpha for each respective symbol is calculated. The associated retrieved beta and just calculated alpha may then be used immediately to calculate the extrinsic information associated with each symbol within this sub-block. Simultaneously, the invention performs skip-back processing to re-calculate the respective alphas and betas for each of the preceding sub-blocks in both directions extending from the block middle to the two block ends. This parallel and simultaneously calculation provides for very fast and efficient processing of the entire block.

This skip-back processing, performed simultaneously with the popping of the appropriate alphas/betas, allows for calculation of the extrinsic values of each of the symbols of the block to be calculated successively beginning from the block middle and extending simultaneously in both directions towards the two block ends.

To enable this type of processing, the block of data is sub-divided into a number of sub-blocks that are intelligently processed to enable extremely fast processing. Generally speaking, the design performs initial processing starting from both block ends, and upon approaching the block middle, the design begins to process the block using skip backs to previous sub-blocks. The design employs a great deal of parallel and simultaneously processing to provide for very fast computation of the various values required to decode the block.

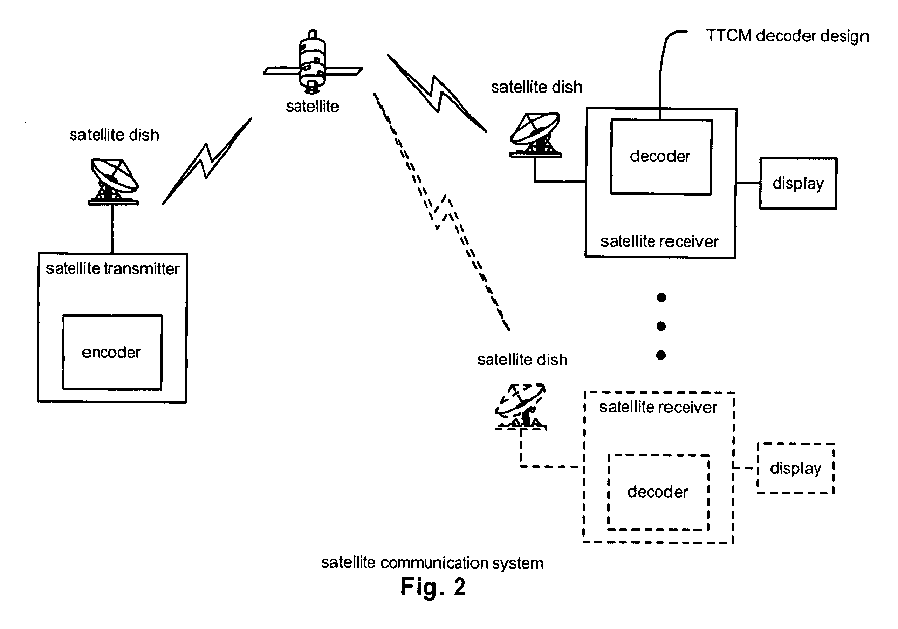

FIG. 2 is a system diagram illustrating an embodiment of a satellite communication system that is built according to the invention. A satellite transmitter is communicatively coupled to a satellite dish that is operable to communicate with a satellite. The satellite transmitter may also be communicatively coupled to a wired network. This wired network may include any number of networks including the Internet, proprietary networks, and/or other wired networks. The satellite transmitter employs the satellite dish to communicate to the satellite via a wireless communication channel. The satellite is able to communicate with one or more satellite receivers (each having a satellite dish). Each of the satellite receivers may also be communicatively coupled to a display.

Here, the communication to and from the satellite may cooperatively be viewed as being a wireless communication channel, or each of the communication to and from the satellite may be viewed as being two distinct wireless communication channels.

For example, the wireless communication "channel" may be viewed as not including multiple wireless hops in one embodiment. In other multi-hop embodiments, the satellite receives a signal received from the satellite transmitter (via its satellite dish), amplifies it, and relays it to satellite receiver (via its satellite dish); the satellite receiver may also be implemented using terrestrial receivers such as satellite receivers, satellite based telephones, and/or satellite based Internet receivers, among other receiver types. In the case where the satellite receives a signal received from the satellite transmitter (via its satellite dish), amplifies it, and relays it, the satellite may be viewed as being a "transponder;" this is a multi-hop embodiment. In addition, other satellites may exist that perform both receiver and transmitter operations in cooperation with the satellite shown. In this case, each leg of an up-down transmission via the wireless communication channel may be considered separately.

In whichever embodiment, the satellite communicates with the satellite receiver. The satellite receiver may be viewed as being a mobile unit in certain embodiments (employing a local antenna); alternatively, the satellite receiver may be viewed as being a satellite earth station that may be communicatively coupled to a wired network in a similar manner in which the satellite transmitter may also be communicatively coupled to a wired network.

The satellite transmitter is operable to encode information (using an encoder) that is to be transmitted to the satellite receiver; the satellite receiver is operable to decode the transmitted signal (using a decoder). Any one or more of the decoders implemented within the satellite receivers may be implemented to support the TTCM decoder design of the invention. The FIG. 2 shows just one of the many embodiments where a decoder may be implemented according to the invention.

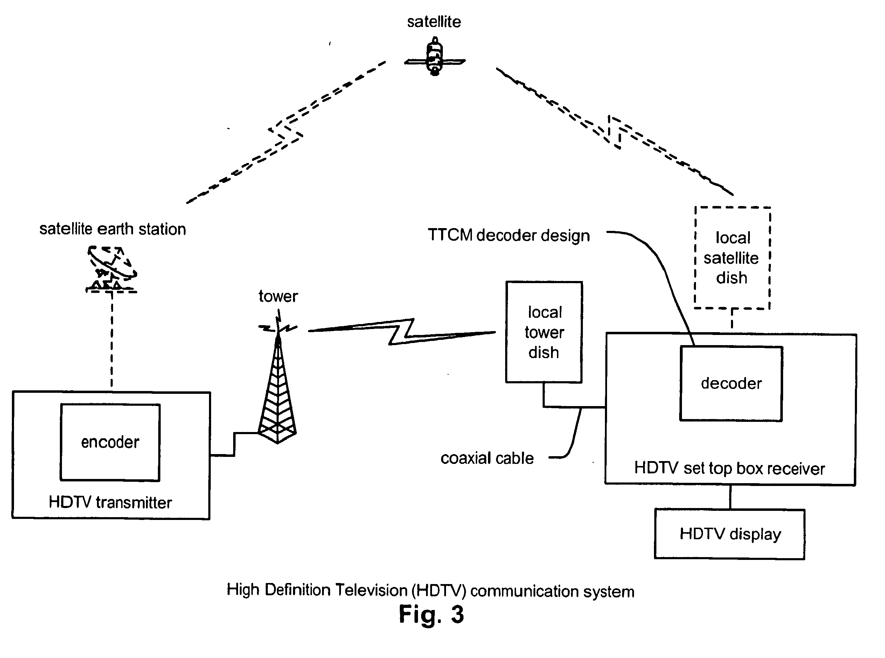

FIG. 3 is a system diagram illustrating an embodiment of a High Definition Television (HDTV) communication system that is built according to the invention. An HDTV transmitter is communicatively coupled to a tower. The HDTV transmitter, using its tower, transmits a signal to a local tower dish via a wireless communication channel. The local tower dish communicatively couples to an HDTV set top box receiver via a coaxial cable or some other communication means. The HDTV set top box receiver includes the functionality to receive the wireless transmitted signal that has been received by the local tower dish; this may include any transformation and/or down-converting that may be needed to accommodate any up-converting that may have been performed before and during transmission of the signal from the HDTV transmitter and its tower. Some example may include transforming down to intermediate frequencies (IFs) and then down to baseband (BB) and/or directly converting down to BB in other embodiments.

The HDTV set top box receiver is also communicatively coupled to an HDTV display that is able to display the demodulated and decoded wireless transmitted signals received by the HDTV set top box receiver and its local tower dish. The HDTV transmitter (via its tower) transmits a signal directly to the local tower dish via the wireless communication channel in this embodiment. In alternative embodiments, the HDTV transmitter may first receive a signal from a satellite, using a satellite earth station that is communicatively coupled to the HDTV transmitter, and then transmit this received signal to the local tower dish via the wireless communication channel. In this situation, the HDTV transmitter operates as a relaying element to transfer a signal originally provided by the satellite that is destined for the HDTV set top box receiver. For example, another satellite earth station may first transmit a signal to the satellite from another location, and the satellite may relay this signal to the satellite earth station that is communicatively coupled to the HDTV transmitter. The HDTV transmitter performs receiver functionality and then transmits its received signal to the local tower dish.

In even other embodiments, the HDTV transmitter employs its satellite earth station to communicate to the satellite via a wireless communication channel. The satellite is able to communicate with a local satellite dish; the local satellite dish communicatively couples to the HDTV set top box receiver via a coaxial cable. This path of transmission shows yet another communication path where the HDTV set top box receiver may communicate with the HDTV transmitter.

In whichever embodiment and whichever signal path the HDTV transmitter employs to communicate with the HDTV set top box receiver, the HDTV set top box receiver is operable to receive communication transmissions from the HDTV transmitter.

The HDTV transmitter is operable to encode information (using an encoder) that is to be transmitted to the HDTV set top box receiver; the HDTV set top box receiver is operable to decode the transmitted signal (using a decoder). The decoder that may be implemented within the HDTV set top box receiver to support the TTCM decoder design of the invention. The FIG. 3 shows just one of the many embodiments where a decoder may be implemented according to the invention.

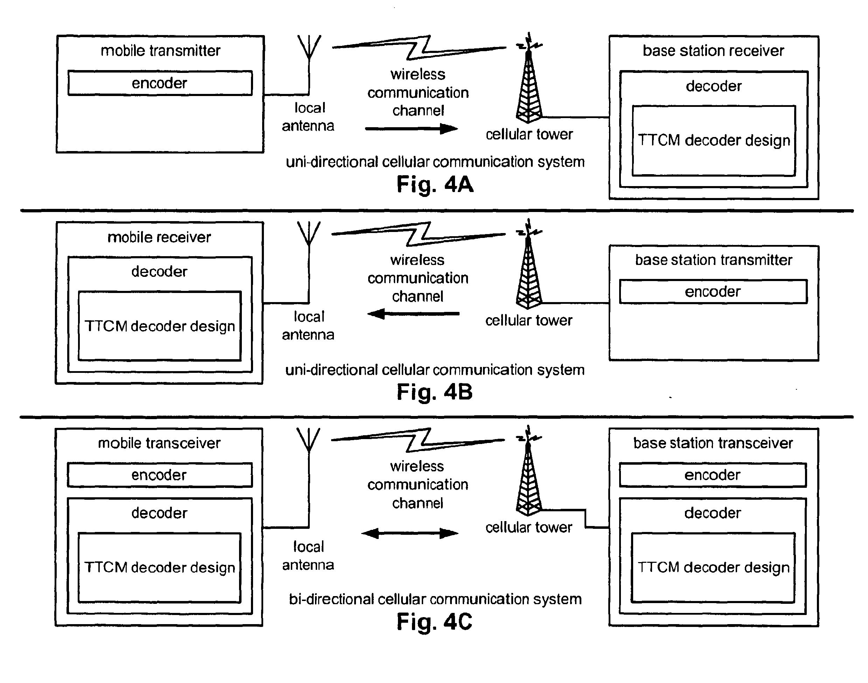

FIG. 4A and FIG. 4B are system diagrams illustrating embodiments of uni-directional cellular communication systems that are built according to the invention.

Referring to the FIG. 4A, a mobile transmitter includes a local antenna communicatively coupled thereto. The mobile transmitter may be any number of types of transmitters including a one way cellular telephone, a wireless pager unit, a mobile computer having transmit functionality, and/or any other type of mobile transmitter. The mobile transmitter transmits a signal, using its local antenna, to a cellular tower via a wireless communication channel. The cellular tower is communicatively coupled to a base station receiver; the receiving tower is operable to receive data transmission from the local antenna of the mobile transmitter that has been communicated via the wireless communication channel. The cellular tower communicatively couples the received signal to the base station receiver.

The mobile transmitter is operable to encode information (using an encoder) that is to be transmitted to the base station receiver; the base station receiver is operable to decode the transmitted signal (using a decoder). The decoder may be implemented within the base station receiver to support the TTCM decoder design of the invention. The FIG. 4A shows yet another of the many embodiments where a decoder may be implemented according to the invention. The FIG. 4A shows a uni-directional cellular communication system where the communication goes from the mobile transmitter to the base station receiver via the wireless communication channel.

Referring to the FIG. 4B, a base station transmitter includes a cellular tower communicatively coupled thereto. The base station transmitter, using its cellular tower, transmits a signal to a mobile receiver via a communication channel. The mobile receiver may be any number of types of receivers including a one-way cellular telephone, a wireless pager unit, a mobile computer having receiver functionality, or any other type of mobile receiver. The mobile receiver is communicatively coupled to a local antenna; the local antenna is operable to receive data transmission from the cellular tower of the base station transmitter that has been communicated via the wireless communication channel. The local antenna communicatively couples the received signal to the mobile receiver.

The base station transmitter is operable to encode information (using an encoder) that is to be transmitted to the mobile receiver; the mobile receiver is operable to decode the transmitted signal (using a decoder). The decoder may be implemented within the mobile receiver to support the TTCM decoder design of the invention. The FIG. 4B shows yet another of the many embodiments where a decoder may be implemented according to the invention. The FIG. 4B shows a uni-directional cellular communication system where the communication goes from the base station transmitter to the mobile receiver via the wireless communication channel.

The FIG. 4C shows a bi-directional cellular communication system where the communication can go to and from the base station transceiver and to and from the mobile transceiver via the wireless communication channel.

Referring to the FIG. 4C, a base station transceiver includes a cellular tower communicatively coupled thereto. The base station transceiver, using its cellular tower, transmits a signal to a mobile transceiver via a communication channel. The reverse communication operation may also be performed. The mobile transceiver is able to transmit a signal to the base station transceiver as well. The mobile transceiver may be any number of types of transceiver including a cellular telephone, a wireless pager unit, a mobile computer having transceiver functionality, or any other type of mobile transceiver. The mobile transceiver is communicatively coupled to a local antenna; the local antenna is operable to receive data transmission from the cellular tower of the base station transceiver that has been communicated via the wireless communication channel. The local antenna communicatively couples the received signal to the mobile transceiver.

The base station transceiver is operable to encode information (using an encoder) that is to be transmitted to the mobile transceiver; the mobile transceiver is operable to decode the transmitted signal (using a decoder). The decoder that may be implemented within either one of the mobile transceiver and the base station transceiver may be implemented as to support the TTCM decoder design of the invention. The FIG. 4C shows yet another of the many embodiments where a decoder may be implemented according to the invention.

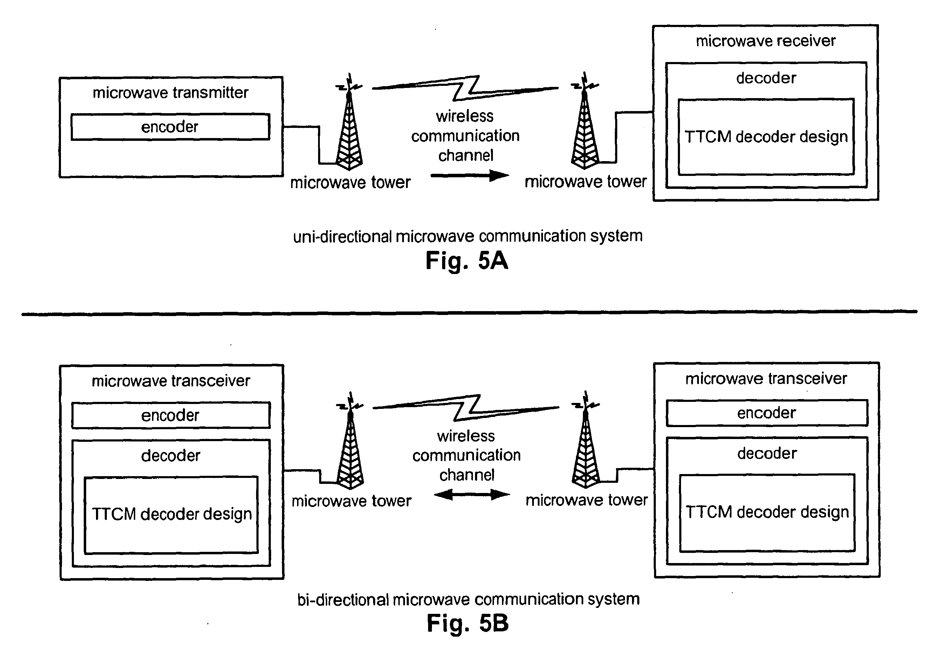

FIG. 5A is a system diagram illustrating an embodiment of a uni-directional microwave communication system that is built according to the invention. A microwave transmitter is communicatively coupled to a microwave tower. The microwave transmitter, using its microwave tower, transmits a signal to a microwave tower via a wireless communication channel. A microwave receiver is communicatively coupled to the microwave tower. The microwave tower is able to receive transmissions from the microwave tower that have been communicated via the wireless communication channel.

The microwave transmitter is operable to encode information (using an encoder) that is to be transmitted to the microwave receiver; the microwave receiver is operable to decode the transmitted signal (using a decoder). The decoder may be implemented within the microwave receiver to support the TTCM decoder design of the invention. The FIG. 5A shows yet another of the many embodiments where a decoder may be implemented according to the invention. The FIG. 5A shows a uni-directional microwave communication system where the communication goes from the microwave transmitter to the microwave receiver via the wireless communication channel.

FIG. 5B is a system diagram illustrating an embodiment of a bi-directional microwave communication system that is built according to the invention. Within the FIG. 5B, a first microwave transceiver is communicatively coupled to a first microwave tower. The first microwave transceiver, using the first microwave tower (the first microwave transceiver's microwave tower), transmits a signal to a second microwave tower of a second microwave transceiver via a wireless communication channel. The second microwave transceiver is communicatively coupled to the second microwave tower (the second microwave transceiver's microwave tower). The second microwave tower is able to receive transmissions from the first microwave tower that have been communicated via the wireless communication channel. The reverse communication operation may also be performed using the first and second microwave transceivers.

Each of the microwave transceivers is operable to encode information (using an encoder) that is to be transmitted to the other microwave transceiver; each microwave transceiver is operable to decode the transmitted signal (using a decoder) that it receives. Each of the microwave transceivers includes an encoder and a decoder. The decoder of either of the transceivers may be implemented to support the TTCM decoder design of the invention. The FIG. 5B shows yet another of the many embodiments where a decoder may be implemented according to the invention.

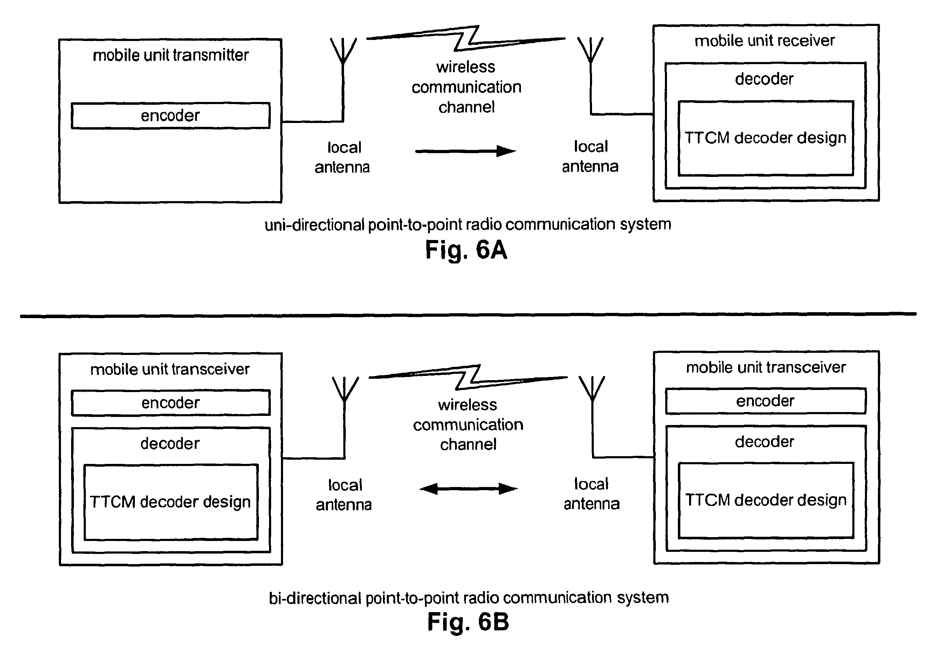

FIG. 6A is a system diagram illustrating an embodiment of a uni-directional point-to-point radio communication system that is built according to the invention. A mobile unit transmitter includes a local antenna communicatively coupled thereto. The mobile unit transmitter, using its local antenna, transmits a signal to a local antenna of a mobile unit receiver via a wireless communication channel.

The mobile unit transmitter is operable to encode information (using an encoder) that is to be transmitted to the mobile unit receiver; the mobile unit receiver is operable to decode the transmitted signal (using a decoder). The decoder may be implemented within the mobile unit receiver to support the TTCM decoder design of the invention. The FIG. 6A shows yet another of the many embodiments where a decoder may be implemented according to the invention. The FIG. 6A shows a uni-directional communication system where the communication goes from the mobile unit transmitter to the mobile unit receiver via the wireless communication channel.

FIG. 6B is a system diagram illustrating an embodiment of a bi-directional point-to-point radio communication system that is built according to the invention. Within the FIG. 6B, a first mobile unit transceiver is communicatively coupled to a first local antenna. The first mobile unit transceiver, using the first local antenna (the first mobile unit transceiver's local antenna), transmits a signal to a second local antenna of a second mobile unit transceiver via a wireless communication channel. The second mobile unit transceiver is communicatively coupled to the second local antenna (the second mobile unit transceiver's local antenna). The second local antenna is able to receive transmissions from the first local antenna that have been communicated via the communication channel. The reverse communication operation may also be performed using the first and second mobile unit transceivers.

Each mobile unit transceiver is operable to encode information (using an encoder) that is to be transmitted to the other mobile unit transceiver; each mobile unit transceiver is operable to decode the transmitted signal (using a decoder) that it receives. The decoder of either of the mobile unit transceivers may be implemented to support the TTCM decoder design of the invention. The FIG. 6B shows yet another of the many embodiments where a decoder may be implemented according to the invention.

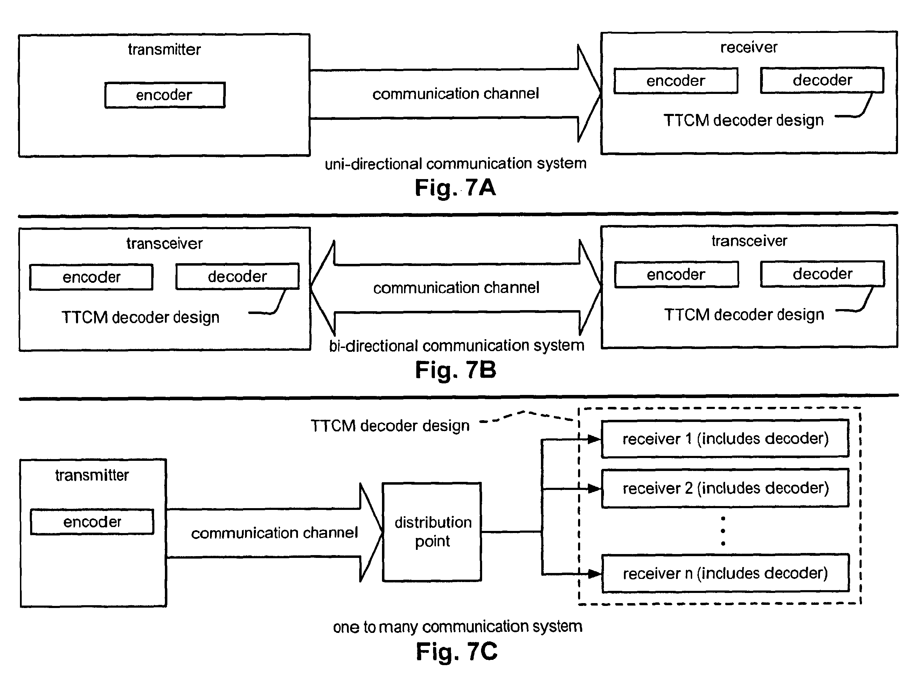

FIG. 7A is a system diagram illustrating an embodiment of a uni-directional communication system that is built according to the invention. A transmitter communicates to a receiver via a uni-directional communication channel. The uni-directional communication channel may be a wireline (or wired) communication channel or a wireless communication channel. The wired media by which the uni-directional communication channel may be implemented are varied, including coaxial cable, fiber-optic cabling, and copper cabling, among other types of "wiring." Similarly, the wireless manners in which the uni-directional communication channel may be implemented are varied, including satellite communication, cellular communication, microwave communication, and radio communication, among other types of wireless communication.

The transmitter is operable to encode information (using an encoder) that is to be transmitted to the receiver; the receiver is operable to decode the transmitted signal (using a decoder). The decoder may be implemented within the receiver to support the TTCM decoder design of the invention. The FIG. 7A shows yet another of the many embodiments where a decoder may be implemented according to the invention. The FIG. 7A shows a uni-directional communication system where the communication goes from the transmitter to the receiver via the communication channel.

FIG. 7B is a system diagram illustrating an embodiment of a bi-directional communication system that is built according to the invention. Within the FIG. 7B, a first transceiver is communicatively coupled to a second transceiver via a bi-directional communication channel. The bi-directional communication channel may be a wireline (or wired) communication channel or a wireless communication channel. The characteristics of the wired and/or wireless communication channel may be varied as also described above.

Each of the transceivers is operable to encode information (using an encoder) that is to be transmitted to the other transceiver; each transceiver is operable to decode the transmitted signal (using a decoder) that it receives. The decoder of either of the transceivers may be implemented to support the TTCM decoder design of the invention. The FIG. 7B shows yet another of the many embodiments where a decoder may be implemented according to the invention.

FIG. 7C is a system diagram illustrating embodiment of a one to many communication system that is built according to the invention. A transmitter is able to communicate, via broadcast in certain embodiments, with a number of receivers, shown as receivers 1, 2, ..., n via a uni-directional communication channel. The uni-directional communication channel may be a wireline (or wired) communication channel or a wireless communication channel. Again, the characteristics of the wired and/or wireless communication channel may be varied as also described above.

A distribution point is employed within the one to many communication system to provide the appropriate communication to the receivers 1, 2, ..., and n. In certain embodiments, the receivers 1, 2, ..., and n each receive the same communication and individually discern which portion of the total communication is intended for that particular receiver.

The transmitter is operable to encode information (using an encoder) that is to be transmitted to the receivers 1, 2, ..., and n; each of the receivers 1, 2, ..., and n is operable to decode the transmitted signal (using a decoder). The decoders within any one or all of the receivers 1, 2, ..., and n may be implemented as to support the TTCM decoder design of the invention. The FIG. 7C shows yet another of the many embodiments where a decoder may be implemented according to the invention.

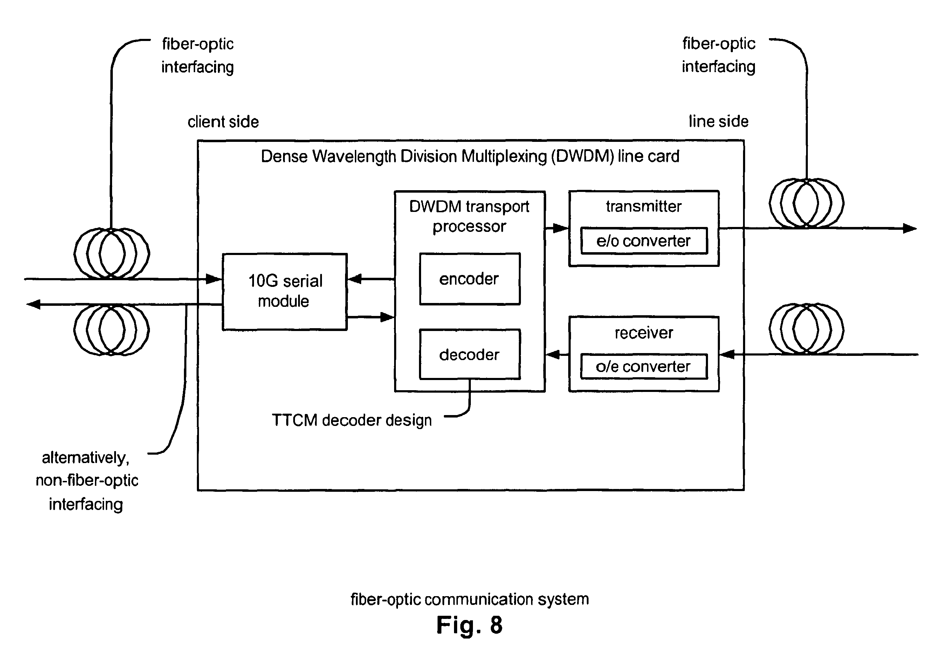

FIG. 8 is a system diagram illustrating an embodiment of a fiber-optic communication system that is built according to the invention. The fiber-optic communication system is operable to support the TTCM decoder design of the invention. The FIG. 8 shows yet another of the many embodiments where a decoder, here implemented as a portion of a system, may be implemented according to the invention. The fiber-optic communication system includes a Dense Wavelength Division Multiplexing (DWDM) line card that is interposed between a line side and a client side.

DWDM is a technology that has gained increasing interest recently. From both technical and economic perspectives, the ability to provide potentially unlimited transmission capacity is the most obvious advantage of DWDM technology. The current investment already made within fiber-optic infrastructure can not only be preserved when using DWDM, but it may even be optimized by a factor of at least 32 according to some estimates. As demands change, more capacity can be added, either by simple equipment upgrades or by increasing the number of wavelengths (lambdas) on the fiber-optic cabling itself, without expensive upgrades. Capacity can be obtained for the cost of the equipment, and existing fiber plant investment is retained. From the bandwidth perspective, some of the most compelling technical advantage of DWDM can be summarized as follows:

The transparency of DWDM: because DWDM is a physical layer architecture (PHY), it can transparently support both Time Division Multiplexing (TDM) and data formats such as asynchronous transfer mode (ATM), Gigabit Ethernet, ESCON, and Fibre Channel with open interfaces over a common physical layer.

The scalability of DWDM: DWDM can leverage the abundance of dark fiber (fiber-optic cabling installed but not yet being used) in many metropolitan area and enterprise networks to quickly meet demand for capacity on point-to-point links and on spans of existing SONET/SDH rings.

The dynamic provisioning capabilities of DWDM: the fast, simple, and dynamic provisioning of network connections give providers the ability to provide high-bandwidth services in days rather than months.

Fiber-optic interfacing is employed at each of the client and line sides of the DWDM line card. The DWDM line card includes a transport processor that includes functionality to support DWDM long haul transport, DWDM metro transport, next-generation SONET/SDH multiplexers, digital cross-connects, and fiber-optic terminators and test equipment. On the line side, the DWDM line card includes a transmitter, that is operable to perform electrical to optical conversion for interfacing to an optical medium, and a receiver, that is operable to perform optical to electrical conversion for interfacing from the optical medium. On the client side, the DWDM line card includes a 10G serial module. That is operable to communicate with any other devices on the client side of the fiber-optic communication system using a fiber-optic interface. Alternatively, the interface may be implemented using non-fiber-optic media, including copper cabling and/or some other type of interface medium.

The DWDM transport processor of the DWDM line card includes a decoder that is used to decode received signals from either one or both of the line and client sides and an encoder that is used to encode signals to be transmitted to either one or both of the line and client sides. The decoder may be implemented within the receiver to support the TTCM decoder design of the invention.

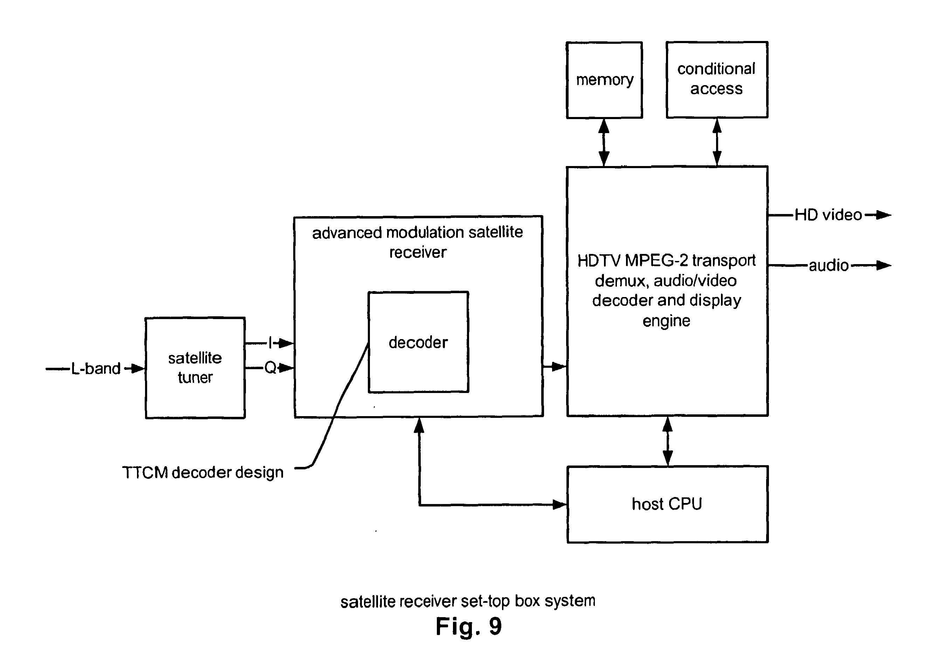

FIG. 9 is a system diagram illustrating an embodiment of a satellite receiver set-top box system that is built according to the invention. The satellite receiver set-top box system includes an advanced modulation satellite receiver that is implemented in an all digital architecture. The satellite receiver set-top box system includes a satellite tuner that receives a signal via the L-band. The satellite tuner extracts I,Q (in-phase and quadrature) components from a signal received from the L-band and provides them to the advanced modulation satellite receiver. The advanced modulation satellite receiver includes an embodiment of the decoder. The decoder may be implemented to support the TTCM decoder design of the invention.

The advanced modulation satellite receiver communicatively couples to an HDTV MPEG-2 (Motion Picture Expert Group) transport de-mux, audio/video decoder and display engine. Both the advanced modulation satellite receiver and the HDTV MPEG-2 transport de-mux, audio/video decoder and display engine communicatively couple to a host Central Processing Unit (CPU). The HDTV MPEG-2 transport de-mux, audio/video decoder and display engine also communicatively couples to a memory module and a conditional access functional block. The HDTV MPEG-2 transport de-mux, audio/video decoder and display engine provides HD video and audio output that may be provided to an HDTV display.

The advanced modulation satellite receiver is a single-chip digital satellite receiver supporting the decoder that is operable to support the TTCM decoder design of the invention. The advanced modulation satellite receiver is operable to receive communication provided to it from a transmitter device that includes an encoder as well.

In addition, several of the following Figures describe particular embodiments that may be used to implement the various embodiment of the TTCM decoder design that allows for greatly improved processing speed and efficiency when decoding received signals.

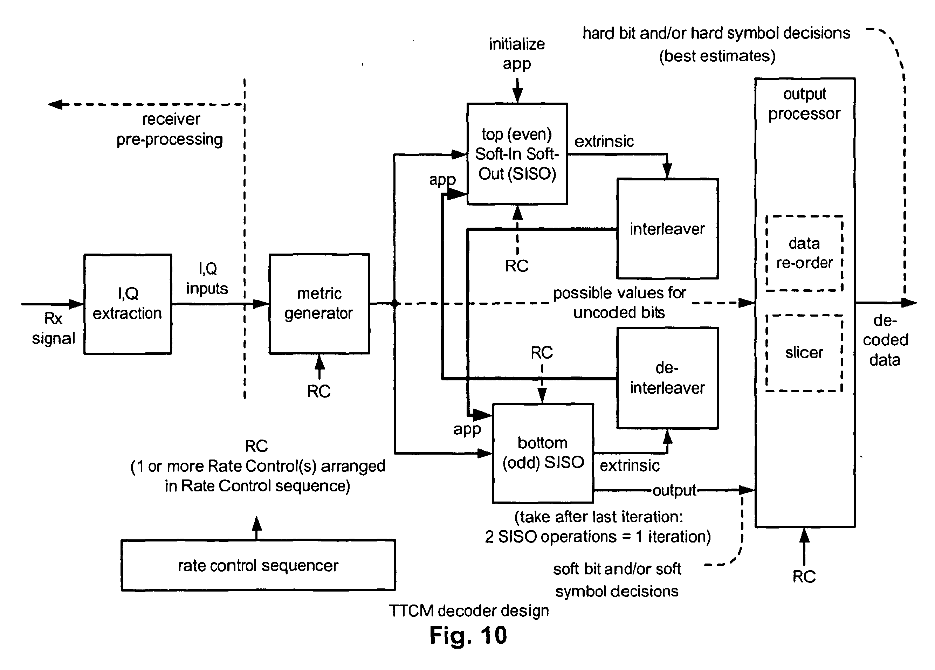

FIG. 10 is a diagram illustrating an embodiment of a TTCM (Turbo Trellis Coded Modulation) decoder design that is built according to the invention. A received signal is provided to an I,Q extraction functional block that extracts the I,Q (in-phase and quadrature) components from the received signal (shown as Rx signal) that are mapped according to a rate control (RC) as determined by a rate control sequencer. This extraction of the I,Q components of the received signal may be viewed as being receiver pre-processing. The I,Q is then mapped according to the modulation's appropriate constellation and mapping. Then, the mapped I,Q is passed to a metric generator that also receives the RC input from the rate control sequencer. The metric generator generates the appropriate metrics that are measured from the received I,Q to the constellation points within the modulation's appropriate constellation and mapping; the metrics are indexed by the mapping of the constellation points within the modulation; these metrics may be viewed as being the scaled Euclidian distances from the location of the actual received symbol to the expected constellation point locations within the modulation.

Thereafter, we then compare the metric associated with uncoded bit (for the situation where the uncoded bit u=0) with the metric associated with uncoded bit (for the situation where the uncoded bit u=1), and we select the smaller metric value. The smaller metric value is deemed a higher likelihood than the larger metric value according to this embodiment's convention; alternatively, in other embodiments, a larger metric value may be used to indicate a higher likelihood as being the correct value. We also select value of u based on which metric has the smaller value. We select the possible value of the uncoded bit u to be 1 or 0 as determined by which of the associated metrics has the smaller value (metric associated with uncoded bit (u=0) or the metric associated with uncoded bit (u=1)). In certain embodiments, we may perform a min* operation that includes a logarithmic correction in selecting the smaller metric. Alternatively, we may perform a max* operation that includes a logarithmic correction in selecting the smaller metric. In even other embodiments, a simple min or max calculation may be employed. It is noted that the various embodiments of the invention may be implemented using the max* operations in lieu of the min* operation when preferred in a given implementation.

The min* calculation may be expressed as follows:

$$\min*(A, B) = \min(A, B) - \ln\left(1 + e^{-|A-B|}\right)$$

The max* calculation may be expressed as follows:

$$\max*\left(A,B\right) = \max\left(A,B\right) + \ln\left(1 + e^{-|A-B|}\right)$$

As an example of this operation, we will consider a received symbol, as determined by a particular RC, that is expected to have a form of $uc_2c_1c_0$, where u represents an uncoded bit, and the c's represent coded bits - all of a 4 bit symbol. We then set u=1 and then u=0 for every combination (looking at $c_2c_1c_0$=111 as an example), so we deal with the two possible values for $uc_2c_1c_0$=0111 and $uc_2c_1c_0$=1111. We then compare the location of the received symbol, as mapped within the constellation, to the two constellation points indexed by 0111 and 1111. We then select from these two constellation points indexed by 0111 and 1111 based on which one has the smaller valued metric. So, in this RC 5 example used here, we reduce the total number of 16 metrics down to 8. We then store these 8 metric values and 8 possible uncoded bit values (indexed by the metrics indices for each symbol in a received frame - a frame may also be referred to as a block), for subsequent use in decoding the uncoded bit after we have decoded the input bits, $i_0i_1$. After we perform decoding of the input bits, $i_0i_1$, then we will know with certainty what the bits $c_2c_1c_0$ are, and then we may directly determine the uncoded bit value u based on these 8 possible uncoded bit values that we have stored.

Continuing on with the decoding process and functionality within this figure, the metrics that are calculated by the metric generator are then provided to a top (even) SISO and simultaneously to a bottom (odd) SISO. Each of these SISOs and calculates forward metrics (alphas) and backward metrics (betas), and extrinsic values according to the particular trellis employed. These alphas, betas, and extrinsics are all calculated for each symbol within a frame (again, a frame may sometimes referred to as a block) that is to be decoded. These calculations of alphas, betas, and extrinsics are all based on the trellis and according to the RC provided by the RC input from the rate control sequencer. The manner in which the alphas, betas, and extrinsics is performed is described in more detail below. The processing of a received block of data employs an approach that employs skip-back processing as is described in more detail below as well.

Starting with the top SISO, after the extrinsic values have been calculated, they are passed to an interleaver after which they is passed to the bottom SISO as "a priori probability" (app) information. Similarly, after extrinsic values have been calculated within the bottom SISO, they are passed to a de-interleaver after which it is passed back to the top SISO as "a priori probability" (app) information. It is noted that a single decoding iteration, within the iterative decoding process of the TTCM decoder design consists of performing two SISO operations; that is to say, the iterative decoding process must pass through both the top (even) SISO and through the bottom (odd) SISO to perform one iteration of decoding.

After a significant level of confidence has been achieved and a solution is being converged upon, or after a predetermined number of decoding iterations have been performed, then the output from the bottom (odd) SISO is passed as output to an output processor. The output processor is operable to perform reordering of the data that is provided to it from the SISO as well as slicing of the received soft decisions. The slicer compares the received soft decision to a threshold and then makes a hard determination based on whether the soft decision value is above or below the threshold. The SISO will provide the data to the output processor in an order that is described in greater detail below. The operation of the SISOs may generally be referred to as calculating soft symbol decisions of the symbol contained within the received symbol. These soft symbol decisions may be performed on a true bit level in certain embodiments. The output processor uses these soft symbol decisions (and/or soft bit decisions) to generate hard symbol decisions (and/or hard bit decisions) for the input bits $i_0i_1$ of the input symbol and to provide decoded output data; these hard symbol and/or hard bit decisions may be viewed as being best estimates of the input symbols and/or the input bits contained therein.

Moreover, in the situation where we have one or more uncoded bits u that results from the coding of the input bits, $i_0i_1$, we then also need to use as many as 8 possible uncoded bit values (indexed by the metrics indices) according to the embodiment described above, so that we can directly determine the value of the uncoded bit.

It is also noted that the app sequence for the top (even) SISO must be initialized before beginning the iterative decoding. The notation for the app sequence *app*[*i*][*j*][*k*] is as follows:

    1. *i* represents the possible binary value of the estimated bit
    2. The positions of the estimated bit are denoted as follows: (*j*=0 refers the first bit into the encoder and *j*=1 refers the second bit into the encoder)
    3. *k* is the index of the symbol's location within the data block (or frame).

More specifically, *k* represents the symbol index of the symbols in a frame of data, *j* is the bit index (*j*=0 for bit $i_1$ and *j*=1 for bit $i_0$), and *i* is the bit value (*i*=0 or 1). For example, *app*[1][0][50] represents the *app* for bit $i_1$ of the 50th

symbol being a value of 1.

At least two ways to initialize *app*[*i*][*j*][*k*] are described below:

1. *app*[*i*][*j*][*k*]=0.0,*i*,*j* ∈ {0,1}, *k* ∈ {0, ..., *N* - 1}. Each and every TTCM coding, using any of the possible combination of RCs for a rate control sequence may use this initialization.

2. The TTCM coding with RC sequence 8 can have different initialization defined as follows.

$$app[0][1][k]=0.0$$
app[1][1][*k*]=MAX, for all possible *k*.
$$app[0] [0] [k]=0.0$$

For the sequence *app*[0][0][*k*], we may first define the sequence based on the rate control sequence using the intermediate variable *pP* and *pP*\* (which denotes the interleaved version of *pP*).

$$pP[1][0][k]=MAX \text{ for RC 8}$$
$$pP[1][0][k]=0.0 \text{ otherwise}$$

Then, we interleave this sequence with de-interleave $\pi^{-1}$ is employed to generate the sequence *pP*\*[1][0][*k*]. Finally, we define the initial *app*[1][0][*k*] as follows:

$$app[1][0][k]=pP[1][0][k] \text{ if k mod2=0}$$
$$app[1][0][k]= pP^*[1][0][k] \text{ if k mod2=1}$$

Moreover, by using the interleaving $\pi$, we can directly define the *app*[1][0][*k*] as follows:

$$app[1][0][k]=MAX \text{ if RC } [\hat{\pi}(k)]=8$$
$$app[1][0][k]= 0.0 \text{ otherwise}$$

Further detail of the TTCM decoding functionality and operation is provided within several of the following Figures.

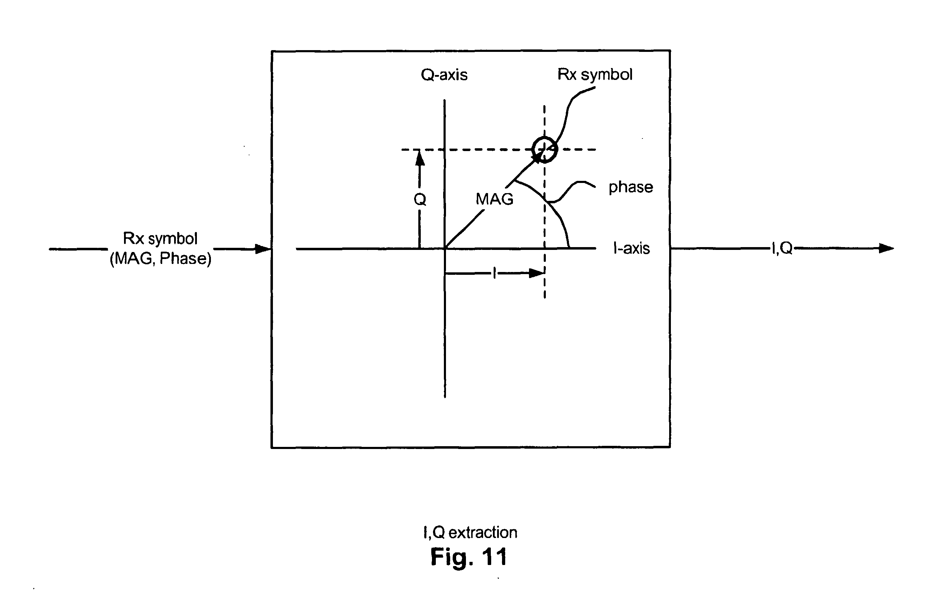

FIG. 11 is a diagram illustrating in-phase and quadrature (I,Q) signal extraction that is performed according to the invention. A received symbol, having a magnitude and phase is provided to an I,Q extraction block. This symbol (or signal) is mapped in a two dimensional space such that an in-phase and a quadrature component may be extracted. This in-phase measurement and the quadrature component are provided as output from the I,Q extraction functional block. The I,Q components of the received signal may be viewed as being the baseband (BB) component of the signal.

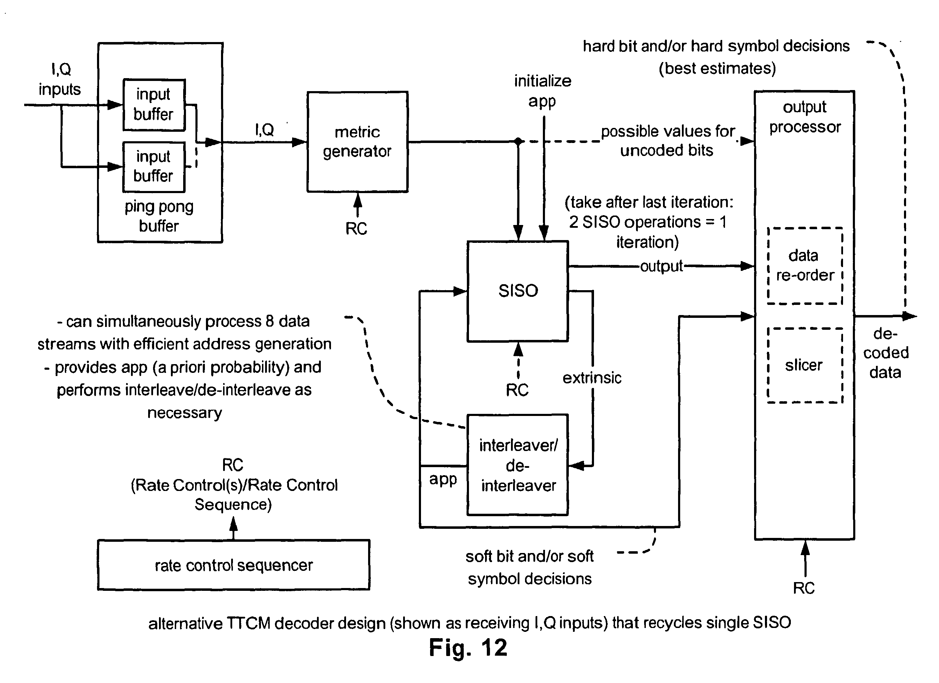

FIG. 12 is a diagram illustrating an alternative embodiment of a TTCM decoder design that is built according to the invention that recycles a single SISO (soft-in soft-out functional block). This alternative TTCM decoder design receives as input the I,Q from a received signal. Similar to embodiments described above, an I,Q extraction functional block may also be employed to extract these I,Q inputs as well when performing receiver pre-processing. A ping pong buffer, employing two input buffers, may be employed for efficient buffering of the I,Q inputs. The I,Q inputs are then passed to the metric generator.

The output of the metric generator is passed to the single SISO; the information necessary to perform decoding of any possible uncoded bits will be passed to the output processor. The SISO calculates forward metrics (alphas), backward metrics (betas), and extrinsic values (exts) according to the trellis employed and provides them to a functional block that is operable to perform both interleaving and de-interleaving (depending upon which particular SISO operation is being performed within the given decoding iteration). The output of the interleaver/de-interleaver functional block is passed back to the SISO as app within a given SISO operation.

Similar to the embodiment described above, it is noted that a single decoding iteration, within the iterative decoding process of the alternative TTCM decoder design consists of performing two SISO operations; that is to say, the iterative decoding process must pass through both the SISO once (when the SISO performs the top SISO functionality) and through the SISO again (when the SISO performs the bottom SISO functionality).

After a significant level of confidence for the soft symbol decisions within the SISO have been achieved and a solution is being converged upon, or after a predetermined number of decoding iterations have been performed, then the output from the SISO is passed as output to the output processor. These soft symbol decisions may also be performed on a true bit level in certain embodiments. The output processor uses these soft symbol decisions to generate hard symbol decisions and to provide decoded output data. It is also noted that a similar app initialization may be performed here as within the embodiment described above.

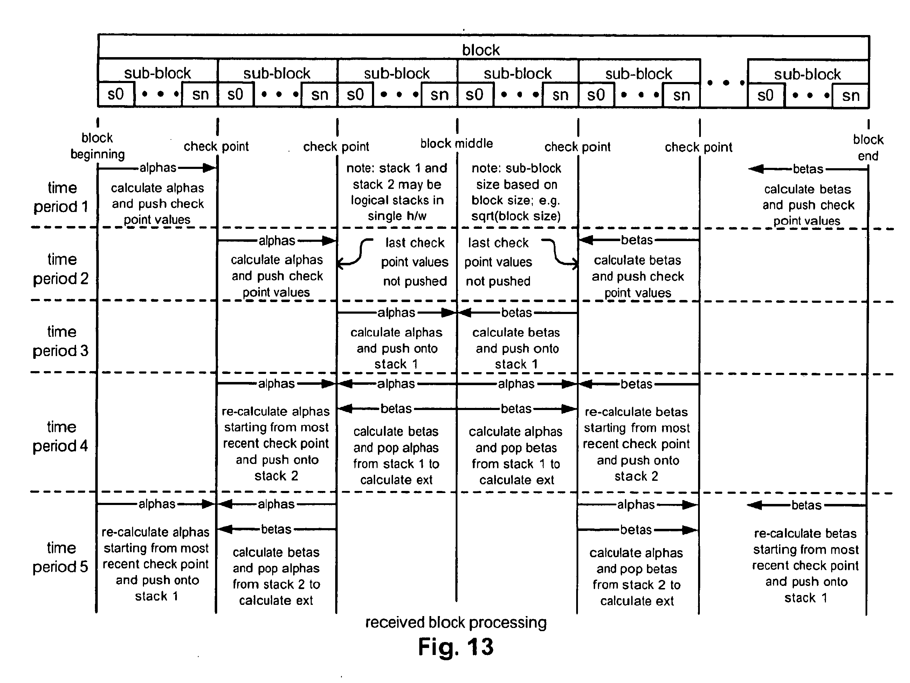

FIG. 13 is a diagram illustrating an embodiment of received block processing that is performed according to the invention. For illustration, the processing of a block of data, sub-divided into sub-blocks each having a number of symbols. The size of each sub-block, and consequently the total number of sub-blocks, into which the block is divided may be intelligently determined as being the square root of the total block size, e.g., sqrt(block size). The processing of the block is shown here as being performed in 5 separate time period intervals. Alternatively, the processing operations shown within the time period 1, time period 2, and time period 3 may all be considering as being a single time period as describe in more detail below. However, for clarity of illustration, these time periods are shown distinctly here so that the processing of the symbols within the sub-blocks of the block may be more fully understood. In addition, the temporary storage of some of the variables may be performed using a stack/FILO memory device; two or more stacks may physically be located within the same portion of hardware and being logically partitioned therein.

Beginning with time period 1, the processing of the block begins simultaneously at both ends of the block (which may be referred to as a block beginning and a block end). Looking at the sub-blocks beginning from the left hand side of the block (block beginning) during time period 1, the forward metrics (alphas) for each symbol of the sub-block is calculated and the check point values, associated with the beginning/initial alpha conditions of the sub-block are pushed onto an alpha/beta stack (e.g., a FILO memory device). Similarly, looking at the sub-blocks beginning from the right hand side of the block (block end) during time period 1, the backward metrics (betas) for each symbol of the sub-block is calculated and the check point values, associated with the beginning/initial beta conditions of the sub-block are pushed onto the alpha/beta stack as well. The processing from both block ends is performed simultaneously when proceeding towards the block middle; it is noted that each and every alpha and beta for the symbols within these sub-blocks are not stored, but only the associated alpha and beta check point values. These check point values are used later for use in skip-back processing to re-calculate the alpha and beta values for each respective sub-block.

Continuing with time period 2, similar processing as described above with respect to time period 1 is performed on the sub-blocks that are the adjacent to the sub-blocks located at the ends of the block. For example, after the recursive calculation of the alphas have been performed on the left most sub-block, and after the check point alpha values have been stored, then the processing continues on to the next sub-block (the 2nd sub-block from the left end of the block) to perform analogous calculations of the alphas for the symbols contained therein and the respective check point alpha values are then stored as well. The check point alpha values for this sub-block as well will be used for use in re-calculation of the alpha values associated with each symbol of this sub-block.

Similarly, after the recursive calculation of the betas have been performed on the right most sub-block, and after the check point beta values have been stored, then the processing continues on to the next sub-block (the 2nd sub-block from the right end of the block) to perform analogous calculations of the betas for the symbols contained therein and the respective check point beta values are then stored as well. The check point beta values for this sub-block as well will be used for use in re-calculation of the beta values associated with each symbol of this sub-block.

However, during the time period 3, when the processing reaches the two sub-blocks that are adjacent to the block middle, then the processing id modified a bit. For example, when processing the two sub-blocks adjacent to the block middle, then the actual values for each and every alpha (or beta, depending on which sub-blocked is being referred) are pushed onto a stack. For example, looking at the sub-block immediately to the left of the block middle, the alpha values are pushed onto a first stack (stack 1); simultaneously, looking at the sub-block immediately to the right of the block middle, the beta values are pushed onto a second stack (stack 2).

After the processing reaches the block middle, as shown in a time period 4, the processing then proceeds to perform two separate operations simultaneously. For example, the processing of betas continues on in the same direction (to the left of the block middle and towards the block beginning) to calculate the betas for the sub-block immediately to the left of the block middle. In addition, the corresponding alpha values that have just been stored, as described above in the time period 3, are also retrieved (popped off the stack 1) for each symbol for which a corresponding beta value has just been calculated. Immediately thereafter, now that the alpha and beta values are available for each of the symbols within this sub-block, they are used to calculate the extrinsic information for that symbol.

An analogous operation takes place simultaneously in the sub-block immediately to the right of the block middle. For example, the processing of alphas continues on in the same direction (to the right of the block middle and towards the block end) to calculate the alphas for the sub-block immediately to the right of the block middle. In addition, the corresponding beta values that have just been stored, as described above in the time period 3, are also retrieved (popped off the stack 2) for each symbol for which a corresponding alpha value has just been calculated. Immediately thereafter, now that the alpha and beta values are available for each of the symbols within this sub-block, they are used to calculate the extrinsic information for that symbol.

As can now be understood, the extrinsic values for each symbol, beginning from the middle and proceeding towards both block ends ([1] from the block middle towards the block beginning on the left hand side and [2] from the block middle towards the block end on the right hand side), may be immediately calculated.

Simultaneously within the time period 4, skip-back processing is performed on the adjacent sub-blocks to re-calculate the alphas and betas, respectively. For example, within the sub-block located adjacent to the left of the sub-block that is located immediately to the left of the block middle, the alpha check point value for the beginning of this sub-block is retrieved for use in re-calculating the alpha values for this sub-block; these re-calculated alphas are them pushed onto the second stack (stack 2).

Similarly, within the sub-block located adjacent to the right of the sub-block that is located immediately to the right of the block middle, the beta check point value for the beginning of this sub-block is retrieved for use in re-calculating the beta values for this sub-block; these re-calculated betas are them pushed onto the second stack (stack 2) as well.

As shown during the time period 5, a similar processing as described above with respect to the time period 4 is performed with the exception that the processing being shifted one sub-block outward towards the two block ends. That is to say, the calculation of the alphas and retrieving of the betas (or alternatively the calculation of the betas and retrieving of the alphas) is performed so that the alpha and beta values for each symbol of this sub-block is made available for immediate calculation of extrinsic values. This processing, as shown in the sub-blocks for the time period 4 and the time period 5 is performed until the two ends of the block are reached (the block beginning and the block end).

Generally speaking, the overall processing of the block may also be described as follows: alpha values are calculated in one direction (starting from one end of the block) and beta values are calculated in the opposite direction (starting from the other end of the block) and the associated check point values alphas/betas are stored. Once the processing reaches the two sub-blocks adjacent to the block middle, then the values for the alphas and beta (depending on the respective sub-block) are stored. Once the processing reaches the actual block middle, then the two processing paths cross one another; the alphas continue to be calculated for each sub-block in the same direction that alphas have been calculated (shown here as from left to right), and the betas continue to be calculated for each sub-block in the same direction that betas have been calculated (shown here as from right to left). Simultaneously, the respective alpha or beta value that was just previously calculated for these respective sub-blocks is retrieved for use in calculating the extrinsic values for these symbols. This processing will continue on, stepping outward one sub-block at a time away from the block middle at a time, until all of the sub-blocks within the total block have been processed. Using this efficient received block processing, it can be seen that once the block middle has been reached, then extrinsic values for each symbol may be successfully calculated and output starting from the block middle and extending simultaneously towards both block ends (towards the block beginning and the block end).

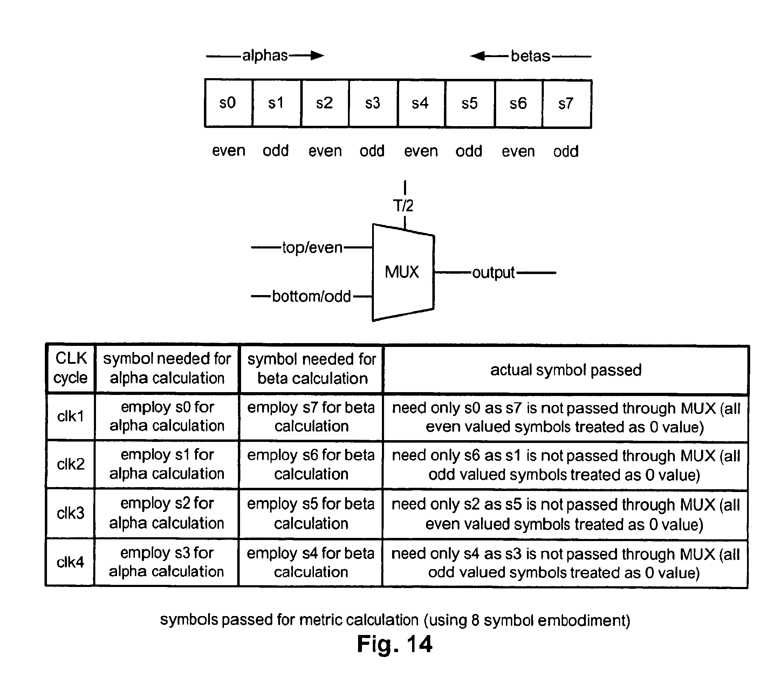

FIG. 14 is a diagram illustrating an embodiment of how symbols may be passed for metric calculation according to the invention (shown using an 8 symbol embodiment). The order of received symbols within a block that are passed for metric calculation will be different than the order in which they are passed from SISO operations, as is described below. For simplicity and clarity of illustration, an eight symbol block is shown here to demonstrate the operation; the symbols of the block being shown as being s0, s1, s2, ..., and s7. The symbols are provided to a MUX (multiplexor) whose selection is 1/2 of the given available clock signal (shown as T/2).

For example, during a first clock cycle (clk1), the symbol s0 should be employed for alpha calculation, and the symbol s7 should be employed for beta calculation. However, the actual passing of symbols for each 1/2 clock cycle (T/2) will alternate as the even and/or odd symbols may be treated as zero valued symbols for every other clock cycle. This is because of the fact that the selection of the MUX is based on the clock having a rate of T/2. During this first clock cycle, only the odd located symbol need be sent, namely, s0; the even located symbol s7 need not be sent since it may be treated as if it were a zero valued symbol according to the operation of the MUX (the MUX will only select the odd located symbol from the block).

As the processing continues, during this second clock cycle (clk2), moving towards the block middle from both of the two ends of the block, all of the odd located symbols may then be treated as if they were zero valued symbols according to the operation of the MUX (the MUX will only select the even located symbol from the block). During the second clock cycle (clk2), the symbol s1 should be employed for alpha calculation, and the symbol s6 should be employed for beta calculation. During this second clock cycle, only the even located symbol need be sent, namely, s6; the even located symbol s1 need not be sent since it may be treated as if it were a zero valued symbol according to the operation of the MUX (the MUX will only select the even located symbol from the block and the odd located symbol may be treated as being a zero valued symbol).

This processing continues for the third and fourth clock cycles (clk3 and clk4, respectively). For example, during the third clock cycle (clk3), the symbol s2 should be employed for alpha calculation, and the symbol s5 should be employed for beta calculation. During this third clock cycle, only the odd located symbol need be sent, namely, s2; the even located symbol s5 need not be sent. In addition, during the fourth clock cycle (clk4), the symbol s3 should be employed for alpha calculation, and the symbol s4 should be employed for beta calculation. During this fourth clock cycle, only the even located symbol need be sent, namely, s4; the odd located symbol s3 need not be sent.

Again, it is noted that this shows the order of the symbols provide for use in performing metric calculation using a metric generator. While an 8 symbol embodiment is described here, it is clear that this approach may be extended to larger sized block as well. This order of output associated with the metric generator is also described below in contradistinction to the order in which output is provided from the SISO.

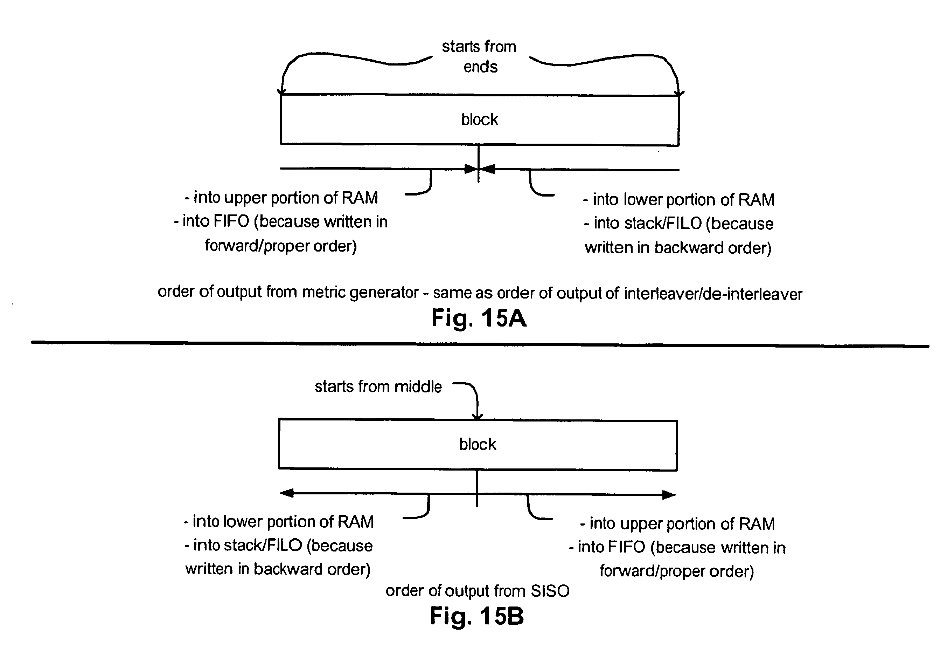

FIG. 15A is a diagram illustrating an embodiment of the order of output from a metric generator according to the invention (which is the same order of output from an interleaver/de-interleaver according to the invention). As described above in greater detail above with respect to the order in which symbols are passed for metric calculation (described above using an 8 symbol embodiment), the order in which output is provided from the metric generator is shown as being provided from the two ends of the block and proceeding towards the block middle. To comply with the convention that the proper order of the block should be from left to right (the order in which the data is received), the manner in which the symbols and associated calculation results are stored is performed differently. This is performed to accommodate the manner of processing of the block that enables the very fast and efficient processing approach of the invention. The storage of these values, to support the processing of the invention, may be performed into a logically partitioned Random Access Memory (RAM) portion. In this embodiment, the RAM is partitioned into an upper portion of RAM and a lower portion of RAM.

More specifically, the output of the metric generator that is associated with the left portion of the block in written into the upper portion of the RAM in a FIFO (First In-First Out) manner. The reason that the data may be written in the FIFO manner is that the data is already in the proper order (being processed from left to right). Alternatively, the output of the metric generator that is associated with the right portion of the block in written into the lower portion of the RAM in a stack/FILO (First In-Last Out) manner. The reason that the data may be written in the FILO manner is that the data is not in the proper order from the perspective of the order in which the data is received (it is being processed from right to left which is the opposite order that is desired). It is also noted that this order of data from the metric generator is the same order of output from the interleaver/de-interleaver.

FIG. 15B is a diagram illustrating an embodiment of the order of output from a SISO (soft-in soft-out functional block) according to the invention. The order of output of the SISO may be viewed as being in contradistinction to the order of output from either the metric generator or the interleaver/de-interleaver. As described above, the output of the SISO will provide the data in an order that begins from the block middle and extends towards both of the two block ends. The manner in which this data should be written is the converse of the manner in which it is done for the metric generator as described above.

The output of the SISO that is associated with the left portion of the block in written into the lower portion of the RAM in a stack/FILO manner. The reason that the data may be written in the FILO manner is that the data is not in the proper order from the perspective of the order in which the data is received (it is being processed from right to left which is the opposite order that is desired). Alternatively, the output of the SISO that is associated with the right portion of the block in written into the upper portion of the RAM in a FIFO manner. The reason that the data may be written in the FIFO manner is that the data is already in the proper order (being processed from left to right).

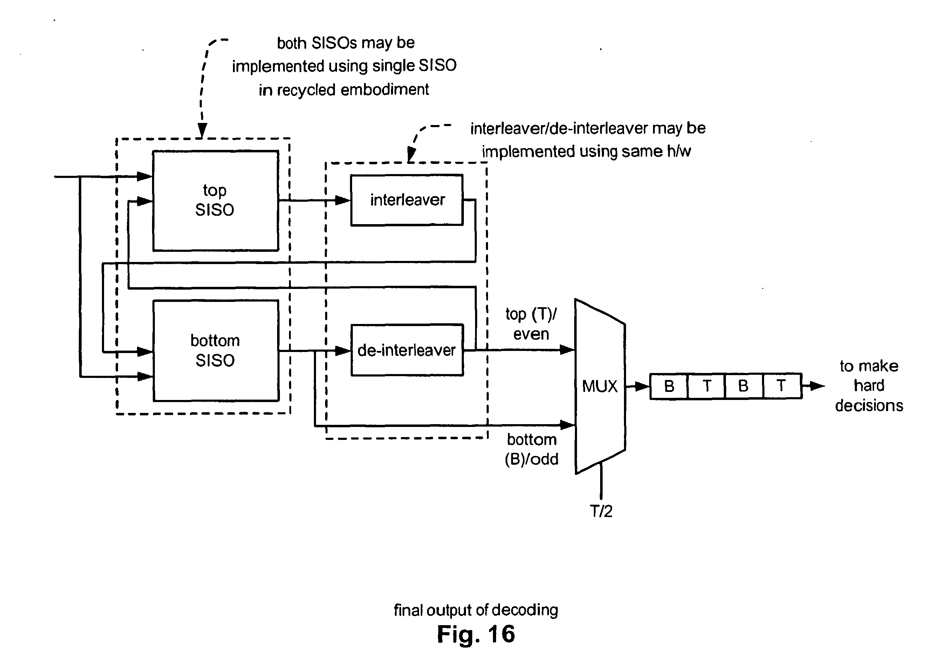

FIG. 16 is a diagram illustrating an embodiment of the final output of decoding that may be provided to make hard decisions according to the invention. In the situation where there may be only one SISO, then the odd symbol should be taken before de-interleave and the even symbol should be taken after de-interleave. It is noted that the TTCM decoder design may be implemented using two separate SISOs or using a single SISO that is recycled to perform both SISO operations for each iteration of decoding.

The functionality of this figure allows for preservation of the order of decoded symbols to match the order in which the input symbols have been input to an encoder (located within a transmitter at the other end of a communication channel) before being received by a receiver (that includes the TTCM decoder design according to the invention).

The final output of decoding ensures the following: when we input a symbol sequence, $S_1S_2S_3S_4$, to the encoder (again, located at a transmitter side of the communication channel), and then when the following encoded symbols $(S_{1-enc}S_{2-enc}S_{3-enc}S_{4-enc})$ are received by the decoder, then the decoded estimates of these received symbols will maintain this same sequential order. A MUX whose selection is provided by a clock signal that is clocked at 1/2 the rate (shown at T/2) will alternatively select the outputs from the output and input of the de-interleaver that is communicatively coupled to the lower SISO. If desired, the functionality of this MUX may be viewed as being within the output processor within any of the embodiments described above. This figure shows an embodiment of how this may be performed in the final decoding step. Again, the functionality shown here may also be supported within embodiments where the functionality of the top and bottom SISOs are implemented as being performed within a single SISO that is recycled according to certain aspects of the invention.

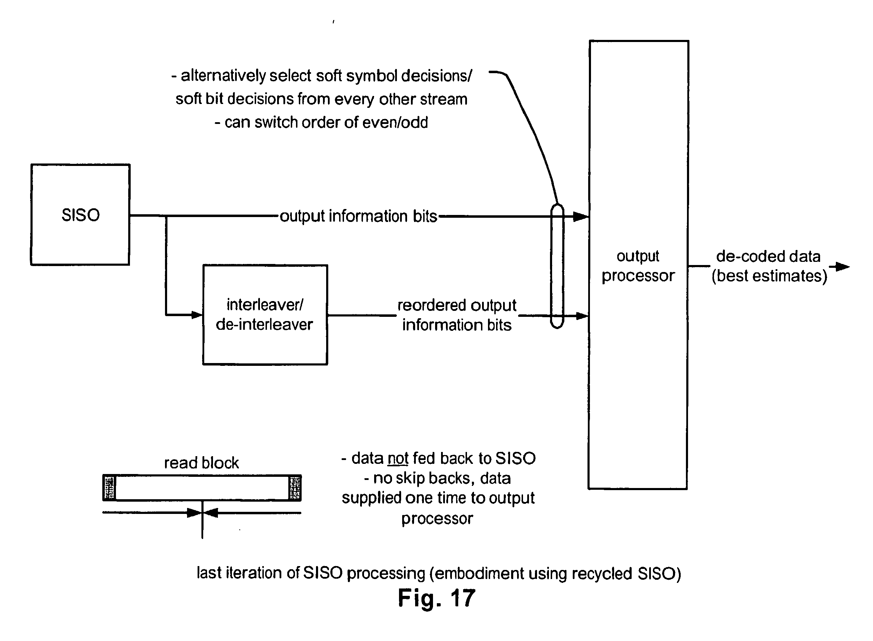

FIG. 17 is a diagram illustrating an embodiment of the last iteration of SISO processing according to the invention (shown in an embodiment using a recycled SISO). This figure may be viewed as illustrating analogous functionality described in the preceding figure with the exception that a single recycled SISO is employed and the alternative selection of the output from the SISO and the interleaver/de-interleaver functionality (shown above as being performed using a MUX) is supported within the output processor. Functionally speaking, the soft symbol decisions and/or soft bit decisions may be viewed as being alternatively selected from every other stream. If desired, the order of selection of even/odd may be modified as desired within a given implementation.

It is also noted here the soft symbol decisions and/or soft bit decisions that are provided from the SISO and interleaver/de-interleaver functional blocks need only be provided to the output processor once; no skip-back processing need be performed as the output processor only needs the data supplied to it once and there is also no feedback of extrinsic information to the SISO during the last iteration of SISO processing.

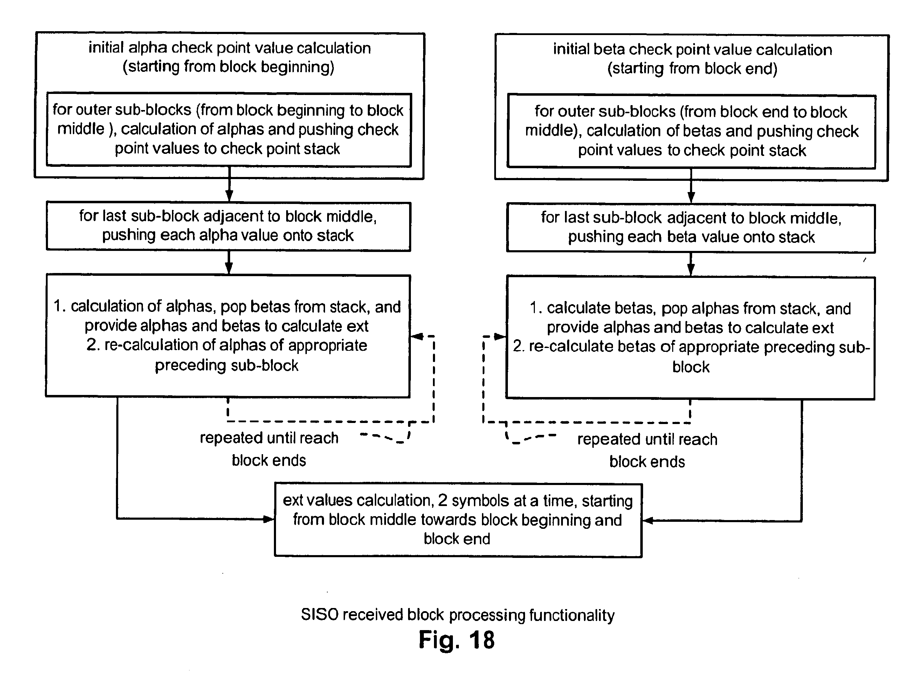

FIG. 18 is a diagram illustrating an embodiment of SISO received block processing functionality that is supported according to the invention. In this figure, the initial alpha calculation and the beta calculation are shown as being performed simultaneously and in parallel. For example, the alpha calculation starts from the block beginning and proceeds towards the block middle. For the outer sub-blocks, being processed from the block beginning towards the block middle(located to the left of the block middle), the SISO received block processing functionality performs calculation of alphas and pushes the appropriate check point values to a check point stack. After the processing reaches the last sub-block that is to adjacent to the block middle, then each alpha value associated with the every symbol is pushed onto an alpha/beta stack.

As mentioned above, the initial alpha calculation is performed simultaneously with the initial beta calculation. For example, the beta calculation starts from the block end and proceeds towards the block middle. For the outer sub-blocks, being processed from the block end towards the block middle, the SISO received block processing functionality performs calculation of betas and pushes the appropriate check point values to a check point stack. After the processing reaches the last sub-block that is to adjacent to the block middle (located to the right of the block middle), then each beta value associated with the every symbol is pushed onto an alpha/beta stack.

The processing functionality then continues by performing skip-back processing for the previous sub-blocks that have been processed when calculating the alphas and betas, respectively, when calculating and storing the appropriate check point values. For example, the skip-back processing associated with the alpha processing involves the calculation of alphas while simultaneously popping the recently calculated betas from the alpha/beta stack. These alpha and beta values correspond to the current symbol are then provided for use in calculating the appropriate extrinsic value for the current symbol. In addition, simultaneously re-calculation of alphas of the appropriate preceding sub-block is performed when the processing of this sub-block is being performed. This process will be repeated until the block ends are met.

Analogous processing is performed in the other direction that includes the re-calculation of betas of the appropriate preceding sub-blocks. For example, the skip-back processing associated with the beta processing involves the calculation of betas while simultaneously popping the recently calculated alphas from the alpha/beta stack. These alpha and beta values correspond to the current symbol are then provided for use in calculating the appropriate extrinsic value for the current symbol.

It can be seen that there is a great deal of simultaneous and parallel processing provided by the invention. Cooperatively, this provides for extremely fast and efficient processing of a received block.

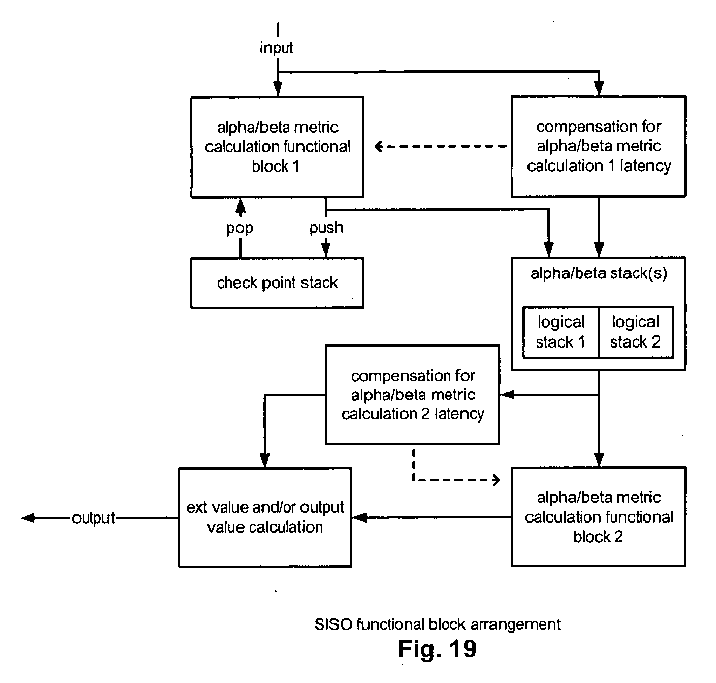

FIG. 19 is a diagram illustrating an embodiment of SISO functional block arrangement according to the invention. The functional block arrangement of the FIG. 19 may be viewed as being one possible hardware implementation arrangement that will support the received block processing according to the invention including the skip-back processing. Input is provided to an alpha/beta calculation functional block 1 for use in performing the initial calculation of the alphas and betas starting from the ends of the block and proceeding towards the block middle. The appropriate check point values for each of the sub-blocks (being alpha check point values or beta check point values) are pushed onto a check point stack.

When the processing has reached the two sub-blocks adjacent to the block middle, then the values for each of the alpha (or beta, respectively) are pushed into a an alpha/beta stack that may be implemented as a logically partitioned stack. Thereafter, when the processing paths of each direction cross one another, a alpha/beta calculation functional block 2 may be implemented to perform the continued calculation of the alphas/betas in the same direction while the alpha/beta calculation functional block 1 performs the re-calculation using skip-back processing as described in other embodiments of the invention. These re-calculated values are then provided to the alpha/beta stack where they are stored in a logical partitioned region thereof.

An extrinsic value and/or output value calculation functional block receives these most recently calculated alpha and beta values calculated by the alpha/beta calculation functional block 2 and simultaneously retrieves the appropriate corresponding alpha or beta for a particular symbol (pops the appropriate corresponding alpha or beta from the appropriate portion of the alpha/beta stack) for use in calculating the extrinsic value associated with the symbol at hand. A compensation functional block is interposed between the alpha/beta stack and the extrinsic value and/or output value calculation functional block to compensate for the latency of the alpha/beta calculation functional block 2. Similarly, a compensation functional block is interposed between the alpha/beta calculation functional block 1 and the alpha/beta stack to compensate for the latency of the alpha/beta calculation functional block 1.

While this figure shows one possible functional block arrangement to support the calculation of the various values that are performed when processing a received block according to the invention, this illustrates just one possible implementation embodiment that may achieve the processing of the received block in the manner described herein.

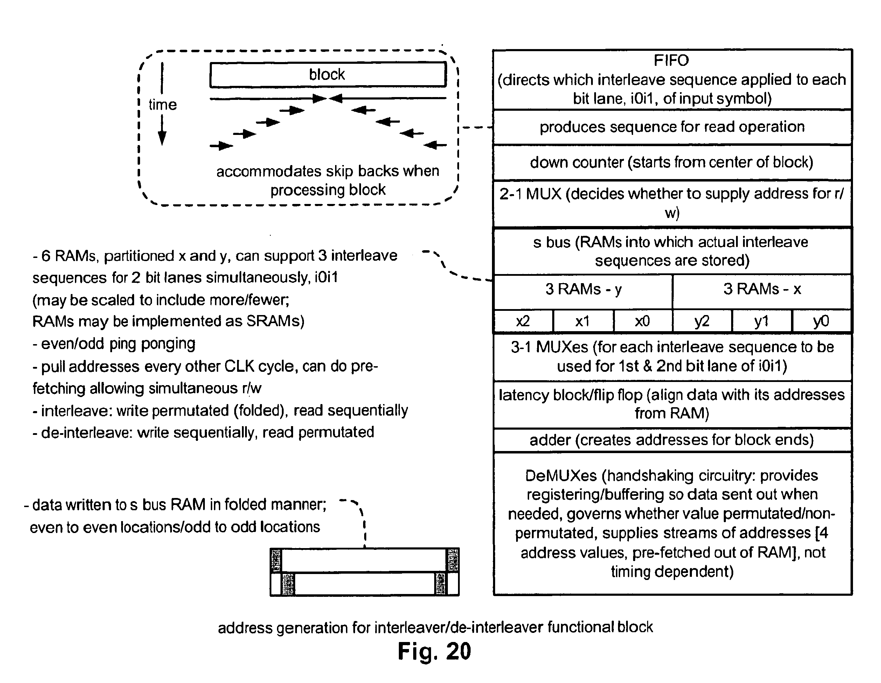

FIG. 20 is a diagram illustrating an embodiment of address generation for an interleaver/de-interleaver functional block according to the invention. This figure shows one possible implementation of how the address generation for the interleaver/de-interleaver may be achieved. The structure is adapted to accommodate the decoding of an encoded symbol having two bit lanes, which may be represented as $i_0i_1$. Starting from the top of the figure, a FIFO is employed that directs which interleave sequence is to be applied to each bit lane of the input symbol. For example, the bit lane $i_0$ may be dealt with differently than the manner in which the bit lane i for is dealt with. Below, a sequence generation portion produces the appropriate sequence that is to be employed for the read operation from the block; this includes also appropriately dealing with the skip-back processing that is performed according to the invention. Below this portion is a down counter that starts at the center of the block (the block middle) and counts down to zero because the data coming out of the SISO starts form the block middle; this need only be performed for one half of the block because the data is folded (half of the data is already being provided in the properly proceeding order). Below this portion is a 2 to 1 MUX that decides whether to supply the address for read or write (r/w); this 2 to 1 MUX is used to select the appropriate address that is generated for both the read and write (r/w) streams.

Central to this functional block is the s bus which is RAM that is logically partitioned into 6 different portions. The s bus includes 6 RAMs, partitioned into an x portion and a y portion that can simultaneously support 3 different interleave sequences for the 2 bit lanes, $i_0i_1$. However, it is noted that the s bus may be logically partitioned (scaled) so as to accommodate more and/or fewer interleave sequences; the RAM may also be implemented as Synchronous RAMs. The data may be written/read using even/odd ping ponging. The addresses may be pulled every other CLK cycle so as to enable prefetching which allows simultaneous r/with to the s bus. The interleave sequence involves writing the data in a permutated (folded) manner and performing reading of the data sequentially. The de-interleave sequence involves write the data in a sequential manner and read the data in a permutated (folded) manner as also described above in other embodiments.

Below the s bus are 2 separate 3 to 1 MUXes. Each 3 to 1 MUX is used for the respective interleave sequence of the 1st and 2nd bit lanes of the input symbol. Below the 3 to 1 MUXes is a latency block/flip flop that is operable to align the data with its addresses from RAM. An adder is located below the block/flip flop to crate the addresses for the block ends; this is to accommodate the folded manner in which the data is to be processed. Below the adder are two separate DeMUXes (de-multiplexors) that may accurately be characterized as being handshaking circuitry that operates to provide the necessary registering/buffering so that the data will be sent out when needed. The DeMUXes govern whether the value is to be provided in a permutated/non-permutated manner; the DeMUXes supply stream of addresses [4 address values, pre-fetched out of RAM] that may be provided in a manner that is not timing dependent.

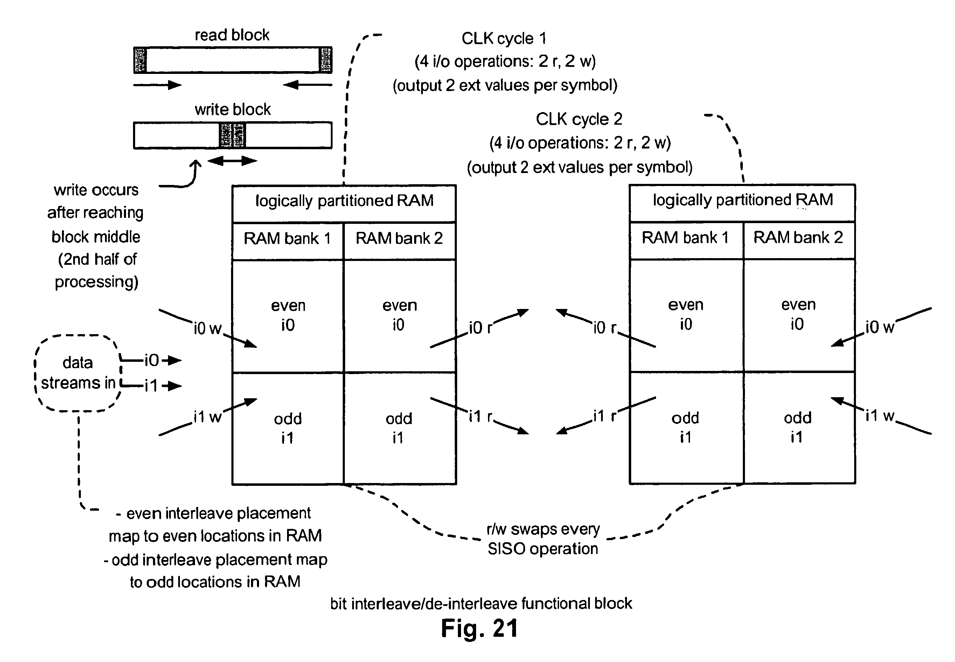

FIG. 21 is a diagram illustrating an embodiment of a bit interleave/de-interleave functional block according to the invention. The bit interleave/de-interleave functional block includes a logically partitioned RAM that includes a RAM bank 1 and a RAM bank 2; each of the RAM bank 1 and the RAM bank 2 is further divided into a top portion and into a bottom portion. The reading from the RAM occurs in a manner beginning from the ends of the block and proceeding towards the block middle, and the writing to the RAM occurs in a manner beginning from the block middle and proceeding to the ends of the block. The even interleave placements map to the even locations within the RAM, and the odd interleave placements map to the odd locations within the RAM. In addition, the reading/writing of the locations within this logically partitioned RAM is swapped every SISO operation.

To illustrate the operation of the bit interleave/de-interleave functional block, two separate clock cycles as shown. Looking at CLK cycle 1, 4 separate input/output (i/o) operations are performed (2 read/2 write) and 2 extrinsic values may be calculated there from. More specifically, the value associated with bit lane $i_0$ is written to the even location of the RAM bank 1, and the value associated with bit lane $i_1$ is written to the odd location of the RAM bank 1. Simultaneously, the previously calculated value associated with bit lane $i_0$ is read from the even location of the RAM bank 2, and the previously calculated value associated with bit lane $i_1$ is read from the odd location of the RAM bank 2.

In the next clock cycle, shown as a CLK cycle 2, 4 separate input/output (i/o) operations are performed (2 read/ 2 write) and 2 extrinsic values may be calculated there from. It is noted that the read/write portions are then swapped during this clock cycle. For example, the previously calculated value associated with bit lane $i_0$ is read from the even location of the RAM bank 1, and the previously calculated value associated with bit lane $i_1$ is read from the odd location of the RAM bank 1. Simultaneously, the value associated with bit lane $i_0$ is written to the even location of the RAM bank 2, and the value associated with bit lane $i_1$ is written to the odd location of the RAM bank 2.

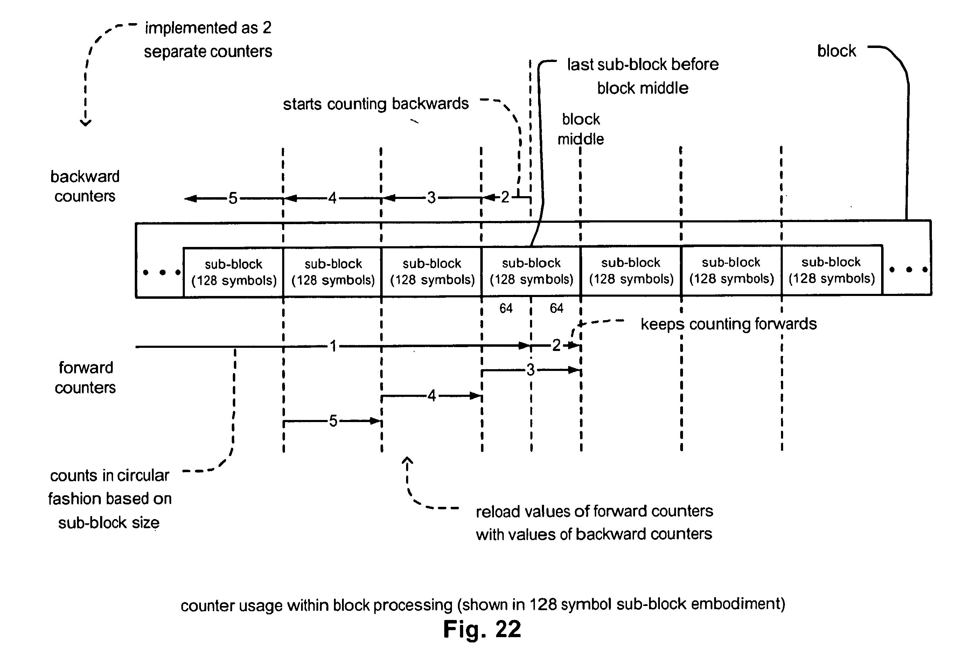

FIG. 22 is a diagram illustrating an embodiment of counter usage within block processing according to the invention (shown in a 128 symbol sub-block embodiment). For clarity of illustration, the use of the counters to support the processing of the invention is shown using only one side of the block. However, the functionality described herein is directly applicable to support the counting of the other half of the block as well.

Two separate counters are implemented to perform forward and backward counting when processing the received block according to the invention including supporting the skip-back processing described herein. Initially, forward counters are employed to count in a circular fashion, based on the sub-block size of the sub-blocks within the block, to accommodate and locate the times at which the check point values (being alpha check point values in this half); this period is shown as being 1. After reaching the sub-block that is located immediately to the left of the block middle, specifically when reaching the middle of this sub-block (half way through the 128 symbols of the sub-block, at symbol 64 within the sub-block), one counter will continue to count forward while a backward counter will then start counting backwards. This is to ensure that when the forward counter reaches the end of this sub-block, then the backward counter will reach the beginning of this sub-block as well.

The corresponding forward and backward counters operate cooperatively to ensure proper sequencing of the calculated alphas, betas, and extrinsic values that are calculated, selectively stored and retrieved, and (in some cases) re-calculated when performing the received block processing to decode the symbols contained therein. The values of the forward counters may be re-loaded with the values of the backward counters to ensure proper synchronization and indexing of the various symbols when performing the decoding of those symbols.

It is also noted that while this embodiment is shown as accommodating a symbol sequence length such that the sub-blocks are of length having 128 symbols each, the values employed with the counters herein may be modified to accommodate symbol sequence lengths of other lengths as well. The use of the forward and backward counters, in cooperation with the re-loading of the values of the forward counters with the values of the backward counters, allows for the proper indexing of the symbols to support the processing of the received block according to the invention.

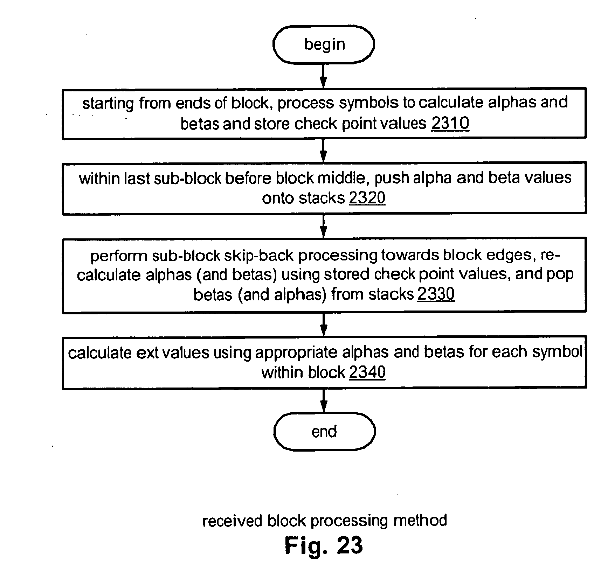

FIG. 23 is a flowchart illustrating an embodiment of a received block processing method that is performed according to the invention. By starting from ends of block, the method begins by processing symbols to calculate alphas and betas and store check point values as shown in a block 2310. Then, when the method continues processing and encounters the last sub-blocks that are located on each side of the block middle, the corresponding alpha and beta values are pushed onto stacks as shown in a block 2320. The method then performs sub-block skip-back processing towards the two block edges as shown in a block 2330. In doing so, the method re-calculates the alphas (and the betas) using the previously stored check point values for the preceding sub-blocks. For the current sub-block, the method simultaneously pops the corresponding betas (and the corresponding alphas) from stacks for use with the most recently calculated alphas in performing extrinsic calculation. The method then actually performs the extrinsic value calculations using these appropriate alphas and betas for each symbol within the block as shown in a block 2340.

In view of the above detailed description of the invention and associated drawings, other modifications and variations will now become apparent.

## Claims

1. A soft-in soft-out functional block, SISO, that calculates a plurality of soft symbol decisions for a block that includes a plurality of encoded symbols arranged into a plurality of sub-blocks, the SISO comprising:

   during a first time period, a first alpha/beta metric calculation functional block successively calculates forward alpha metrics starting from the block beginning towards the block middle, and selectively stores forward alpha metrics associated with the beginning of a sub-block within a first half of the block as alpha check point values;
   during the first time period, the first alpha/beta metric calculation functional block also successively calculates backward beta metrics starting from the block end towards the block middle and selectively stores backward beta metrics associated with the end of a sub-block within a second half of the block as beta check point values;
   during a second time period, upon reaching a final sub-block of the first half of the block, the first alpha/beta metric calculation functional block calculates a forward alpha metric for each encoded symbol contained therein and stores the calculated forward alpha metrics;
   during the second time period, upon reaching a final sub-block of the second half of the block, the first alpha/beta metric calculation functional block also calculates a backward beta metric for each encoded symbol contained therein and stores the calculated backward beta metrics;

   wherein a third time period occurs after the first alpha/beta metric calculation functional block completes processing both the final sub-block of the first half of the block and the final sub-block of the second half of the block;
   during the third time period, a second alpha/beta metric calculation functional block successively calculates forward alpha metrics for each symbol of the final sub-block of the second half of the block;
   during the third time period, the second alpha/beta metric calculation functional block successively calculates backward beta metrics for each symbol of the final sub-block of the first half of the block;
   during the third time period, the first alpha/beta metric calculation functional block performs skip-back processing to successively re-calculate forward alpha metrics for each encoded symbol of a sub-block that precedes the final sub-block within the first half of the block and stores the re-calculated forward alpha metrics; and
   during the third time period, the first alpha/beta metric calculation functional block performs skip-back processing to successively re-calculate backward beta metrics for each encoded symbol of a sub-block that precedes the final sub-block within the second half of the block and stores the re-calculated backward beta metrics.

2. The SISO of claim 1, further comprising an extrinsic value calculation functional block calculating a corresponding soft symbol decision for each encoded symbol within the final sub-block of the first half of the block using the stored forward alpha metrics and the calculated backward beta metrics.

3. The SISO of claim 2, wherein the SISO is communicatively coupled to an output processor that selectively receives the plurality of soft symbol decisions in a way that each of the plurality of soft symbol decisions is ordered in the same order as the plurality of encoded symbols received in the SISO and calculates a corresponding hard symbol decision there from.

4. The SISO of claim 1, further comprising an extrinsic value calculation functional block calculating a corresponding soft symbol decision for each encoded symbol within the final sub-block of the second half of the block using the stored backward beta metrics and the calculated forward alpha metrics.

5. The SISO of claim 4, wherein the SISO is communicatively coupled to an output processor that selectively receives the plurality of soft symbol decisions in a way that each of the plurality of soft symbol decisions is ordered in the same order as the plurality of encoded symbols received in the SISO and calculates a corresponding hard symbol decision there from.

6. The SISO of claim 1, wherein, during the second time period, the first alpha/beta metric calculation functional block stores the forward alpha metrics and the backward beta metrics by pushing them onto a common alpha/beta stack.

7. The SISO of claim 1, wherein the plurality of encoded symbols is encoded according to a rate control sequence having a plurality of rate controls arranged in a period.

8. The SISO of claim 7, wherein a rate control of the plurality of rate controls includes a modulation that includes a constellation having a mapping.

9. The SISO of claim 7, wherein a first rate control of the plurality of rate controls includes a first modulation that includes a first constellation having a first mapping; and
wherein a second rate control of the plurality of rate controls includes a second modulation that includes a second constellation having a second mapping.

10. A communication system containing a communication receiver, which comprises a decoder including the SISO of claim 1, wherein the communication system is one of a satellite communication system, a High Definition. Television communication system, a cellular communication system, a microwave communication system, a point-to-point communication system, a uni-directional communication system, a bi-directional communication system, a one to many communication system, and a fiber-optic communication system.

11. A decoder that decodes a block that includes a plurality of encoded symbols arranged into a plurality of sub-blocks, the decoder comprising:

   the soft-in soft-out functional block, SISO, of claim 1 that, based on a plurality of trellis metrics, calculates a first plurality of extrinsic values for each encoded symbol of the plurality of encoded symbols;
   an interleaver/de-interleaver, communicatively coupled to the SISO, that interleaves the first plurality of extrinsic values to generate a first "a priori probability" information;

   wherein the SISO, based on the plurality of trellis metrics, calculates a second plurality of extrinsic values for each encoded symbol of the plurality of encoded symbols;
   wherein the interleaver/ de-interleaver, that is communicatively coupled to the SISO, de-interleaves the second plurality of extrinsic values to generate a second "a priori probability" information;
   wherein the first "a priori probability" information is fed back to the SISO during a first SISO operation;
   wherein the second "a priori probability" information is fed back to the SISO during a second SISO operation;
   wherein the SISO performs the first SISO operation and the second SISO operation during at least one iteration of iterative decoding to generate a plurality of soft symbol decisions, each soft symbol decision of the plurality of soft symbol decisions corresponds to an encoded symbol of the plurality of encoded symbols.

12. The decoder of claim 11, wherein the plurality of encoded symbols is encoded according to a rate control sequence having a plurality of rate controls arranged in a period.

**13.** A received, block processing method that decodes a block that includes a plurality of encoded symbols arranged into a plurality of sub-blocks, the method comprising:

during a first time period, successively calculating forward alpha metrics starting from the block beginning towards the block middle, and selectively storing forward alpha metrics associated with the beginning of a sub-block within a first half of the block as alpha check point values;

during the first time period, successively calculating backward beta metrics starting from the block end towards the block middle and selectively storing backward beta metrics associated with the end of a sub-block within a second half of the block as beta check point values;

during a second time period, upon reaching a final sub-block of the first half of the block, calculating a forward alpha metric for each encoded symbol contained therein and storing the calculated forward alpha metrics;

during the second time period, upon reaching a final sub-block of the second half of the block, calculating a backward beta metric for each encoded symbol contained therein and storing the calculated backward beta metrics;

wherein a third time period occurs after completing the processing of both the final sub-block of the first half of the block and the final sub-block of the second half of the block;

during the third time period, successively calculating forward alpha metrics for each symbol of the final sub-block of the second half of the block;

during the third time period, successively calculating backward beta metrics for each symbol of the final sub-block of the first half of the block;

during the third time period, performing skip-back processing to successively re-calculate forward alpha metrics for each encoded symbol of a sub-block that precedes the final sub-block within the first half of the block and storing the re-calculated forward alpha metrics; and

during the third time period, performing skip-back processing to successively re-calculate backward beta metrics for each encoded symbol of a sub-block that precedes the final sub-block within the second half of the block and storing the re-calculated backward beta metrics.

**14.** The method of claim 13, further comprising calculating a corresponding soft symbol decision for each encoded symbol within the final sub-block of the first half of the block using the stored forward alpha metrics and the calculated backward beta metrics.

**Patentansprüche**

**1.** Soft-In-Soft-Out-Funktionsblock, SISO, der eine Mehrzahl von weichen Symbolentscheidungen für einen Block berechnet, welcher eine Mehrzahl von codierten Symbolen umfasst, die in einer Mehrzahl von Unterblöcken angeordnet sind, wobei der SISO aufweist:

während eines ersten Zeitraums berechnet ein erster Alpha/Beta-Metrikberechnungs-Funktionsblock nacheinander Vorwärts-Alphametriken ab dem Blockanfang zur Blockmitte hin und speichert Vorwärts-Alphametriken, die dem Anfang eines Unterblocks zugeordnet sind, selektiv in einer ersten Hälfte des Blocks als Alpha-Prüfpunktwerte;

während des ersten Zeitraums berechnet der erste Alpha/Beta-Metrikberechnungs-Funktionsblock auch nacheinander Rückwärts-Beta-Metriken ab dem Blockende zur Blockmitte hin und speichert Rückwärts-Beta-Metriken, die dem Ende eines Unterblocks zugeordnet sind, selektiv in einer zweiten Hälfte des Blocks als Beta-Prüfpunktwerte;

während eines zweiten Zeitraums berechnet der erste Alpha/Beta-Metrikberechnungs-Funktionsblock beim Erreichen eines abschließenden Unterblocks der ersten Hälfte des Blocks eine Vorwärts-Alpha-Metrik für jedes codierte Symbol, das darin enthalten ist, und speichert die berechneten Vorwärts-Alphametriken;

während des zweiten Zeitraums berechnet der erste Alpha/Beta-Metrikberechnungs-Funktionsblock beim Erreichen eines abschließenden Unterblocks der zweiten Hälfte des Blocks auch eine Rückwärts-Beta-Metrik für jedes codierte Symbol, das darin enthalten ist, und speichert die berechneten Rückwärts-Beta-Metriken;

wobei ein dritter Zeitraum eintritt, nachdem der erste Alpha/Beta-Metrikberechnungs-Funktionsblock die Verarbeitung sowohl des abschließenden Unterblocks der ersten Hälfte des Blocks als auch des abschließenden Unterblocks der zweiten Hälfte des Blocks abgeschlossen hat;

während des dritten Zeitraums berechnet ein zweiter Alpha/Beta-Metrikberechnungs-Funktionsblock nacheinander Vorwärts-Alphametriken für jedes Symbol des abschließenden Unterblocks der zweiten Hälfte des Blocks; während des dritten Zeitraums berechnet der zweite Alpha/Beta-Metrikberechnungs-Funktionsblock nacheinander Rückwärts-Beta-Metriken für jedes Symbol des abschließenden Unterblocks der ersten Hälfte des Blocks; während des dritten Zeitraums führt der erste Alpha/Beta-Metrikberechnungs-Funktionsblock eine Rücksprungverarbeitung durch, um nacheinander Vorwärts-Alphametriken für jedes codierte Symbol eines Unterblocks, der dem abschließenden Unterblock in der ersten Hälfte des Blocks voraus geht, erneut zu berechnen, und speichert die erneut berechneten Vorwärts-Alphametriken; und während des dritten Zeitraums führt der erste Alpha/Beta-Metrikberechnungs-Funktionsblock eine Rücksprungverarbeitung durch, um nacheinander Rückwärts-Beta-Metriken für jedes codierte Symbol eines Unterblocks, der dem abschließenden Unterblock in der zweiten Hälfte des Blocks voraus geht, erneut zu berechnen, und speichert die erneut berechneten Rückwärts-Beta-Metriken.

2. SISO nach Anspruch 1, welcher ferner einen Funktionsblock zur Berechnung extrinsischer Werte aufweist, der eine entsprechende weiche Symbolentscheidung für jedes codierte Symbol in dem abschließenden Unterblock der ersten Hälfte des Blocks unter Verwendung der gespeicherten Vorwärts-Alphametriken und der berechneten Rückwärts-Beta-Metriken berechnet.

3. SISO nach Anspruch 2, wobei der SISO kommunikationsmäßig mit einem Ausgabeprozessor gekoppelt ist, der die Mehrzahl von weichen Symbolentscheidungen auf eine solche Weise selektiv empfängt, dass jede der Mehrzahl von weichen Symbolentscheidungen in der gleichen Reihenfolge wie die Mehrzahl von in dem SISO empfangenen codierten Symbolen geordnet ist, und daraus eine entsprechende harte Symbolentscheidung berechnet.

4. SISO nach Anspruch 1, welcher ferner einen Funktionsblock zur Berechnung extrinsischer Werte aufweist, der eine entsprechende weiche Symbolentscheidung für jedes codierte Symbol in dem abschließende Unterblock der zweiten Hälfte des Blocks unter Verwendung der gespeicherten Rückwärts-Beta-Metriken und der berechneten Vorwärts-Alphametriken berechnet.

5. SISO nach Anspruch 4, wobei der SISO kommunikationsmäßig mit einem Ausgabeprozessor gekoppelt ist, der die Mehrzahl von weichen Symbolentscheidungen auf eine solche Weise selektiv empfängt, dass jede der Mehrzahl von weichen Symbolentscheidungen in der gleichen Reihenfolge wie die Mehrzahl von in dem SISO empfangenen codierten Symbolen geordnet ist, und daraus eine entsprechende harte Symbolentscheidung berechnet.

6. SISO nach Anspruch 1, wobei während des zweiten Zeitraums der erste Alpha/Beta-Metrikberechnungs-Funktionsblock die Vorwärts-Alphametriken und die Rückwärts-Beta-Metriken speichert, indem er sie auf einen gemeinsamen Alpha/Beta-Stapel schiebt.

7. SISO nach Anspruch 1, wobei die Mehrzahl von codierten Symbolen gemäß einer Ratensteuersequenz codiert ist, bei der eine Mehrzahl von Ratensteuerungen in einer Periode angeordnet ist.

8. SISO nach Anspruch 7, wobei eine Ratensteuerung der Mehrzahl von Ratensteuerungen eine Modulation umfasst, die eine Konstellation mit einem Mapping umfasst.

9. SISO nach Anspruch 7, wobei eine erste Ratensteuerung der Mehrzahl von Ratensteuerungen eine erste Modulation umfasst, die eine erste Konstellation mit einem ersten Mapping umfasst; und wobei eine zweite Ratensteuerung der Mehrzahl von Ratensteuerungen eine zweite Modulation umfasst, die eine zweite Konstellation mit einem zweiten Mapping umfasst.

10. Kommunikationssystem, das einen Kommunikationsempfänger enthält, der einen Decoder einschließlich des SISO von Anspruch 1 aufweist, wobei das Kommunikationssystem eines von einem Satelliten-Kommunikationssystem, einem HDTV-Kommunikationssystem, einem zellulären Kommunikationssystem, einem Mikrowellen-Kommunikationssystem; einem Punkt-zu-Punkt-Kommunikationssystem, einem unidirektionalen Kommunikationssystem, einem bidirektionalen Kommunikationssystem, einem One-to-Many-Kommunikationssystem und einem Faseroptik-Kommunikationssystem ist.

11. Decoder zum Decodieren eines Blocks, der eine Mehrzahl von in einer Mehrzahl von Unterblöcken angeordneten codierten Symbolen umfasst, wobei der Decoder aufweist:

den Soft-In-Soft-Out-Funktionsblock, SISO, von Anspruch 1, der auf der Grundlage einer Mehrzahl von Trellismetriken eine erste Mehrzahl von extrinsischen Werten für jedes codierte Symbol der Mehrzahl von codierten Symbolen berechnet;

einen kommunikationsmäßig mit dem SISO gekoppelten Interleaver/Deinterleaver, der die erste Mehrzahl von extrinsischen Werten einer Interleaver-Verarbeitung unterzieht, um erste "a priori-Wahrscheinlichkeit"-Informationen zu erzeugen;

wobei der SISO auf der Grundlage der Mehrzahl von Trellismetriken eine zweite Mehrzahl von extrinsischen Werten für jedes codierte Symbol der Mehrzahl von codierten Symbolen berechnet;

wobei der kommunikationsmäßig mit dem SISO gekoppelte Interleaver/Deinterleaver die zweite Mehrzahl von extrinsischen Werten einer Deinterleaver-Verarbeitung unterzieht, um zweite "a priori-Wahrscheinlichkeit"-Informationen zu erzeugen;

wobei die ersten "a priori-Wahrscheinlichkeit"-Informationen während einer ersten SISO-Operation zurück an den SISO geliefert werden;

wobei die zweiten "a priori-Wahrscheinlichkeit"-Informationen während einer zweiten SISO-Operation zurück an den SISO geliefert werden;

wobei der SISO die erste SISO-Operation und die zweite SISO-Operation während mindestens einer Iteration einer iterativen Decodierung durchführt, um eine Mehrzahl von weichen Symbolentscheidungen zu erzeugen, wobei jede weiche Symbolentscheidung der Mehrzahl von weichen Symbolentscheidungen einem codierten Symbol der Mehrzahl von codierten Symbolen entspricht.

12. Decoder nach Anspruch 11, wobei die Mehrzahl von codierten Symbolen gemäß einer Ratensteuersequenz codiert ist, bei der eine Mehrzahl von Ratensteuerungen in einer Periode angeordnet ist.

13. Verfahren zur Verarbeitung eines empfangenen Blocks, welches einen Block decodiert, der eine Mehrzahl von codierten Symbolen umfasst, die in einer Mehrzahl von Unterblöcken angeordnet sind, wobei das Verfahren umfasst:

während eines ersten Zeitraums, aufeinander folgendes Berechnen von Vorwärts-Alphametriken ab dem Blockanfang zur Blockmitte hin und selektives Speichern der Vorwärts-Alphametriken, die dem Anfang eines Unterblocks zugeordnet sind, in einer ersten Hälfte des Blocks als Alpha-Prüfpunktwerte;

während des ersten Zeitraums, aufeinander folgendes Berechnen von Rückwärts-Beta-Metriken ab dem Blockende zur Blockmitte hin und selektives Speichern von Rückwärts-Beta-Metriken, die dem Ende eines Unterblocks zugeordnet sind, in einer zweiten Hälfte des Blocks als Beta-Prüfpunktwerte;

während eines zweiten Zeitraums, beim Erreichen eines abschließenden Unterblocks der ersten Hälfte des Blocks, Berechnen einer Vorwärts-Alpha-Metrik für jedes codierte Symbol, das darin enthalten ist, und Speichern der berechneten Vorwärts-Alphametriken;

während des zweiten Zeitraums, beim Erreichen eines abschließenden Unterblocks der zweiten Hälfte des Blocks, Berechnen einer Rückwärts-Beta-Metrik für jedes codierte Symbol, das darin enthalten ist, und Speichern der berechneten Rückwärts-Beta-Metriken;

wobei ein dritter Zeitraum eintritt, nachdem die Verarbeitung sowohl des abschließenden Unterblocks der ersten Hälfte des Blocks als auch des abschließenden Unterblocks der zweiten Hälfte des Blocks abgeschlossen ist;

während des dritten Zeitraums, aufeinander folgendes Berechnen von Vorwärts-Alphametriken für jedes Symbol des abschließenden Unterblocks der zweiten Hälfte des Blocks;

während des dritten Zeitraums, aufeinander folgendes Berechnen von Rückwärts-Beta-Metriken für jedes Symbol des abschließenden Unterblocks der ersten Hälfte des Blocks;

während des dritten Zeitraums, Durchführen einer Rücksprungverarbeitung zum aufeinander folgenden erneuten Berechnen von Vorwärts-Alphametriken für jedes codierte Symbol eines Unterblocks, der dem abschließenden Unterblock in der ersten Hälfte des Blocks voraus geht, und Speichern der erneut berechneten Vorwärts-Alphametriken; und

während des dritten Zeitraums, Durchführen einer Rücksprungverarbeitung zum aufeinander folgenden erneuten Berechnen von Rückwärts-Beta-Metriken für jedes codierte Symbol eines Unterblocks, der dem abschließenden Unterblock in der zweiten Hälfte des Blocks voraus geht, und Speichern der erneut berechneten Rückwärts-Beta-Metriken.

14. Verfahren nach Anspruch 13, welches ferner das Berechnen einer entsprechenden weichen Symbolentscheidung für jedes codierte Symbol in dem abschließenden Unterblock der ersten Hälfte des Blocks unter Verwendung der gespeicherten Vorwärts-Alphametriken und der berechneten Rückwärts-Beta-Metriken umfasst.

**EP 1 367 732 B1**

**Revendications**

1. Bloc fonctionnel à entrées et sorties souples, SISO, qui calcule une pluralité de décisions souples sur des symboles pour un bloc qui comprend une pluralité de symboles codés agencés selon une pluralité de sous-blocs, le bloc SISO comprenant les étapes suivantes :

   pendant une première période, un premier bloc fonctionnel de calcul de mesure alpha/bêta calcule successivement des mesures alpha avant en partant du début du bloc et en allant vers le milieu du bloc, et enregistre de manière sélective les mesures alpha avant associées au début d'un sous-bloc à l'intérieur d'une première moitié du bloc en tant que valeurs de point de contrôle alpha ;
   pendant la première période, le premier bloc fonctionnel de calcul de mesure alpha/bêta calcule successivement également des mesures bêta arrière en partant de la fin du bloc et en allant vers le milieu du bloc et enregistre de manière sélective les mesures bêta arrière associées à la fin d'un sous-bloc à l'intérieur d'une seconde moitié du bloc en tant que valeurs de point de contrôle bêta ;
   pendant une deuxième période, lorsqu'il a atteint un sous-bloc final de la première moitié du bloc, le premier bloc fonctionnel de calcul de mesure alpha/bêta calcule une mesure alpha avant pour chaque symbole codé contenu dans celui-ci et enregistre les mesures alpha avant calculées ;
   pendant la deuxième période, lorsqu'il a atteint un sous-bloc final de la seconde moitié du bloc, le premier bloc fonctionnel de calcul de mesure alpha/bêta calcule également une mesure bêta arrière pour chaque symbole codé contenu dans celui-ci et enregistre les mesures bêta arrière calculées ;

   dans lequel une troisième période commence une fois que le premier bloc fonctionnel de calcul de mesure alpha/bêta a terminé le traitement à la fois du sous-bloc final de la première moitié du bloc et du sous-bloc final de la seconde moitié du bloc ;
   pendant la troisième période, un second bloc fonctionnel de calcul de mesure alpha/bêta calcule successivement des mesures alpha avant pour chaque symbole du sous-bloc final de la seconde moitié du bloc ;
   pendant la troisième période, le second bloc fonctionnel de calcul de mesure alpha/bêta calcule successivement des mesures bêta arrière pour chaque symbole du sous-bloc final de la première moitié du bloc ;
   pendant la troisième période, le premier bloc fonctionnel de calcul de mesure alpha/bêta effectue un traitement de retour arrière pour recalculer successivement des mesures alpha avant pour chaque symbole codé d'un sous-bloc qui précède le sous-bloc final à l'intérieur de la première moitié du bloc et enregistre les mesures alpha avant recalculées ; et
   pendant la troisième période, le premier bloc fonctionnel de calcul de mesure alpha/bêta effectue un traitement de retour arrière pour recalculer successivement des mesures bêta arrière pour chaque symbole codé d'un sous-bloc qui précède le sous-bloc final à l'intérieur de la seconde moitié du bloc et enregistre les mesures bêta arrière recalculées.

2. Bloc SISO selon la revendication 1, comprenant en outre un bloc fonctionnel de calcul de valeur extrinsèque qui calcule une décision souple correspondante sur un symbole pour chaque symbole codé à l'intérieur du sous-bloc final de la première moitié du bloc en utilisant les mesures alpha avant enregistrées et les mesures bêta arrière calculées.

3. Bloc SISO selon la revendication 2, dans lequel le bloc SISO est couplé de manière à pouvoir communiquer avec un processeur de sortie qui reçoit de manière sélective la pluralité de décisions souples sur des symboles de telle sorte que chacune de la pluralité de décisions souples sur des symboles soit ordonnée selon le même ordre que la pluralité de symboles codés reçus dans le bloc SISO et qui calcule une décision dure correspondante sur un symbole à partir de celle-ci.

4. Bloc SISO selon la revendication 1, comprenant en outre un bloc fonctionnel de calcul de valeur extrinsèque qui calcule une décision souple correspondante sur un symbole pour chaque symbole codé à l'intérieur du sous-bloc final de la seconde moitié du bloc en utilisant les mesures bêta arrière enregistrées et les mesures alpha avant calculées.

5. Bloc SISO selon la revendication 4, dans lequel le bloc SISO est couplé de manière à pouvoir communiquer avec un processeur de sortie qui reçoit de manière sélective la pluralité de décisions souples sur des symboles de telle sorte que chacune de la pluralité de décisions souples sur des symboles soit ordonnée selon le même ordre que la pluralité de symboles codés reçus dans le bloc SISO et qui calcule une décision dure correspondante sur un symbole à partir de celle-ci.

**6.** Bloc SISO selon la revendication 1, dans lequel, pendant la seconde période, le premier bloc fonctionnel de calcul de mesure alpha/bêta enregistre les mesures alpha avant et les mesures bêta arrière en les poussant sur une pile alpha/bêta commune.

**7.** Bloc SISO selon la revendication 1, dans lequel la pluralité de symboles codés sont codés selon une séquence de commande de débit ayant une pluralité de commandes de débit agencés dans une période.

**8.** Bloc SISO selon la revendication 7, dans lequel une commande de débit de la pluralité de commandes de débit comprend une modulation qui comprend une constellation ayant une mise en correspondance.

**9.** Bloc SISO selon la revendication 7, dans lequel une première commande de débit de la pluralité de commandes de débit comprend une première modulation qui comprend une première constellation ayant une première mise en correspondance ; et
dans lequel une seconde commande de débit de la pluralité de commandes de débit comprend une seconde modulation qui comprend une seconde constellation ayant une seconde mise en correspondance.

**10.** Système de communication contenant un récepteur de communication, qui comporte un décodeur comprenant le bloc SISO de la revendication 1, dans lequel le système de communication est l'un d'un système de communication par satellite, d'un système de communication par télévision à haute définition, d'un système de communication cellulaire, d'un système de communication à micro-ondes, d'un système de communication point à point, d'un système de communication unidirectionnel, d'un système de communication bidirectionnel, d'un système de communication un à plusieurs, et d'un système de communication par fibres optiques.

**11.** Décodeur qui décode un bloc comprenant une pluralité de symboles codés agencés selon une pluralité de sous-blocs, le décodeur comprenant :

le bloc à entrées et sorties souples, SISO, de la revendication 1 lequel, à partir d'une pluralité de mesures de treillis, calcule une première pluralité de valeurs extrinsèques pour chaque symbole codé de la pluralité de symboles codés ;
un entrelaceur-désentrelaceur, couplé de manière à pouvoir communiquer avec le bloc SISO, qui entrelace la première pluralité de valeurs extrinsèques pour générer une première information de "probabilité a priori" ;

dans lequel le bloc SISO, à partir de la pluralité de mesures de treillis, calcule une seconde pluralité de valeurs extrinsèques pour chaque symbole codé de la pluralité de symboles codés ;
dans lequel l'entrelaceur-désentrelaceur, qui est couplé de manière à pouvoir communiquer avec le bloc SISO, désentrelace la seconde pluralité de valeurs extrinsèques pour générer une seconde information de "probabilité a priori" ;
dans lequel la première information de "probabilité a priori" est renvoyée par rétroaction au bloc SISO pendant une première opération SISO ;
dans lequel la seconde information de "probabilité a priori" est renvoyée par rétroaction au bloc SISO pendant une seconde opération SISO ;
dans lequel le bloc SISO effectue la première opération SISO et la seconde opération SISO pendant au moins une itération d'un décodage itératif pour générer une pluralité de décisions souples sur des symboles, chaque décision souple sur un symbole de la pluralité de décisions souples sur des symboles correspondant à un symbole codé de la pluralité de symboles codés.

**12.** Décodeur selon la revendication 11, dans lequel la pluralité de symboles codés sont codés selon une séquence de commande de débit ayant une pluralité de commandes de débit agencées dans une période.

**13.** Procédé de traitement de bloc reçu qui décode un bloc comprenant une pluralité de symboles codés agencés selon une pluralité de sous-blocs, le procédé consistant à :

pendant une première période, calculer successivement des mesures alpha avant en partant du début du bloc et en allant vers le milieu du bloc, et enregistrer de manière sélective les mesures alpha avant associées au début d'un sous-bloc à l'intérieur d'une première moitié du bloc en tant que valeurs de point de contrôle alpha ;
pendant la première période, calculer successivement des mesures bêta arrière en partant de la fin du bloc et en allant vers le milieu du bloc et enregistrer de manière sélective les mesures bêta arrière associées à la fin d'un sous-bloc à l'intérieur d'une seconde moitié du bloc en tant que valeurs de point de contrôle bêta ;

dans une deuxième période, après avoir atteint un sous-bloc final de la première moitié du bloc, calculer une mesure alpha avant pour chaque symbole codé contenu dans celui-ci et enregistrer les mesures alpha avant calculées ;

dans la deuxième période, après avoir atteint un sous-bloc final de la seconde moitié du bloc, calculer une mesure bêta arrière pour chaque symbole codé contenu dans celui-ci et enregistrer les mesures bêta arrière calculées ;

dans lequel une troisième période commence à l'issue du traitement à la fois du sous-bloc final de la première moitié du bloc et du sous-bloc final de la seconde moitié du bloc ;

pendant la troisième période, calculer successivement des mesures alpha avant pour chaque symbole du sous-bloc final de la seconde moitié du bloc ;

pendant la troisième période, calculer successivement des mesures bêta arrière pour chaque symbole du sous-bloc final de la première moitié du bloc ;

pendant la troisième période, effectuer un traitement de retour arrière pour recalculer successivement des mesures alpha avant pour chaque symbole codé d'un sous-bloc qui précède le sous-bloc final à l'intérieur de la première moitié du bloc et enregistrer les mesures alpha avant recalculées ; et

pendant la troisième période, effectuer un traitement de retour arrière pour recalculer successivement des mesures bêta arrière pour chaque symbole codé d'un sous-bloc qui précède le sous-bloc final à l'intérieur de la seconde moitié du bloc et enregistrer les mesures bêta arrière recalculées.

14. Procédé selon la revendication 13, consistant en outre à calculer une décision souple correspondante sur un symbole pour chaque symbole codé à l'intérieur du sous-bloc final de la première moitié du bloc en utilisant les mesures alpha avant enregistrées et les mesures bêta arrière calculées.

1.
calculate alphas
sequentially forward
through block

——alpha——➤ ——alpha——➤ ——alpha——➤ ——alpha——➤        ——alpha——➤

| s1 | s2 | s3 | s4 | • • • | sn |
|----|----|----|----|-------|----|

2.
subsequently calculate
betas sequentially
backward through block

◀——beta—— ◀——beta—— ◀——beta—— ◀——beta——        ◀——beta——

some disadvantages:
1. requires lots of real estate for extensive amount of memory
(lots of storage of intermediate calculations)
2. large amount of memory r/w (overburdened memory management)
3. slow computation (inherently bottlenecked approach)

3.
finally calculate extrinsic
information for each
symbol using alphas and
betas

received block processing
**(prior art)**
**Fig. 1**

satellite communication system

Fig. 2

satellite

satellite earth station

TTCM decoder design

local satellite dish

tower

local tower dish

decoder

encoder

coaxial cable

HDTV set top box receiver

HDTV transmitter

HDTV display

High Definition Television (HDTV) communication system

**Fig. 3**

EP 1 367 732 B1

EP 1 367 732 B1

| mobile transmitter | | base station receiver |
| --- | --- | --- |
| encoder | | decoder |
| | | TTCM decoder design |

local antenna

wireless communication channel

cellular tower

uni-directional cellular communication system

**Fig. 4A**

| mobile receiver | | base station transmitter |
| --- | --- | --- |
| decoder | | encoder |
| TTCM decoder design | | |

local antenna

wireless communication channel

cellular tower

uni-directional cellular communication system

**Fig. 4B**

| mobile transceiver | | base station transceiver |
| --- | --- | --- |
| encoder | | encoder |
| decoder | | decoder |
| TTCM decoder design | | TTCM decoder design |

local antenna

wireless communication channel

cellular tower

bi-directional cellular communication system

**Fig. 4C**

uni-directional microwave communication system

**Fig. 5A**

bi-directional microwave communication system

**Fig. 5B**

EP 1 367 732 B1

uni-directional point-to-point radio communication system

**Fig. 6A**

bi-directional point-to-point radio communication system

**Fig. 6B**

EP 1 367 732 B1

transmitter

encoder

communication channel

receiver

encoder  decoder

TTCM decoder design

uni-directional communication system

**Fig. 7A**

transceiver

encoder  decoder

TTCM decoder design

communication channel

transceiver

encoder  decoder

TTCM decoder design

bi-directional communication system

**Fig. 7B**

TTCM decoder design

transmitter

encoder

communication channel

distribution point

receiver 1 (includes decoder)

receiver 2 (includes decoder)

receiver n (includes decoder)

one to many communication system

**Fig. 7C**

fiber-optic
interfacing

fiber-optic
interfacing

client side

line side

**Dense Wavelength Division Multiplexing (DWDM) line card**

DWDM transport
processor

transmitter

e/o converter

10G serial
module

encoder

decoder

receiver

o/e converter

TTCM decoder design

alternatively,
non-fiber-optic
interfacing

fiber-optic communication system

**Fig. 8**

satellite receiver set-top box system

# Fig. 9

TTCM decoder design

**Fig. 10**

EP 1 367 732 B1

Rx symbol
(MAG, Phase)

Q-axis

Rx symbol

Q

MAG

phase

I-axis

I

I,Q

I,Q extraction

**Fig. 11**

Fig. 12

alternative TTCM decoder design (shown as receiving I,Q inputs) that recycles single SISO

EP 1 367 732 B1

block

| sub-block | sub-block | sub-block | sub-block | sub-block | • • • | sub-block |
|---|---|---|---|---|---|---|
| s0 • • • sn | s0 • • • sn | s0 • • • sn | s0 • • • sn | s0 • • • sn | | s0 • • • sn |

block beginning    check point    check point    block middle    check point    check point    block end

**time period 1**

←—alphas—→
calculate alphas and push check point values

note: stack 1 and stack 2 may be logical stacks in single h/w

note: sub-block size based on block size; e.g. sqrt(block size)

←—betas—→
calculate betas and push check point values

**time period 2**

←—alphas—→
calculate alphas and push check point values

last check point values not pushed

last check point values not pushed

←—betas—→
calculate betas and push check point values

**time period 3**

←—alphas—→
calculate alphas and push onto stack 1

←—betas—→
calculate betas and push onto stack 1

**time period 4**

←—alphas—→
re-calculate alphas starting from most recent check point and push onto stack 2

←—alphas—→
←—betas—→
calculate betas and pop alphas from stack 1 to calculate ext

←—alphas—→
←—betas—→
calculate alphas and pop betas from stack 1 to calculate ext

←—betas—→
re-calculate betas starting from most recent check point and push onto stack 2

**time period 5**

←—alphas—→
re-calculate alphas starting from most recent check point and push onto stack 1

←—alphas—→
←—betas—→
calculate betas and pop alphas from stack 2 to calculate ext

←—alphas—→
←—betas—→
calculate alphas and pop betas from stack 2 to calculate ext

←—betas—→
re-calculate betas starting from most recent check point and push onto stack 1

received block processing

## Fig. 13

| CLK cycle | symbol needed for alpha calculation | symbol needed for beta calculation | actual symbol passed |
|---|---|---|---|
| clk1 | employ s0 for alpha calculation | employ s7 for beta calculation | need only s0 as s7 is not passed through MUX (all even valued symbols treated as 0 value) |
| clk2 | employ s1 for alpha calculation | employ s6 for beta calculation | need only s6 as s1 is not passed through MUX (all odd valued symbols treated as 0 value) |
| clk3 | employ s2 for alpha calculation | employ s5 for beta calculation | need only s2 as s5 is not passed through MUX (all even valued symbols treated as 0 value) |
| clk4 | employ s3 for alpha calculation | employ s4 for beta calculation | need only s4 as s3 is not passed through MUX (all odd valued symbols treated as 0 value) |

symbols passed for metric calculation (using 8 symbol embodiment)

Fig. 14

starts from
ends

block

- into upper portion of RAM
- into FIFO (because written in
  forward/proper order)

- into lower portion of RAM
- into stack/FILO (because
  written in backward order)

order of output from metric generator - same as order of output of interleaver/de-interleaver

**Fig. 15A**

starts from middle

block

- into lower portion of RAM
- into stack/FILO (because
  written in backward order)

- into upper portion of RAM
- into FIFO (because written in
  forward/proper order)

order of output from SISO

**Fig. 15B**

both SISOs may be
implemented using single SISO
in recycled embodiment

interleaver/de-interleaver may be
implemented using same h/w

top
SISO

interleaver

bottom
SISO

de-interleaver

top (T)/
even

bottom
(B)/odd

MUX

| B | T | B | T |

T/2

to make
hard
decisions

final output of decoding

**Fig. 16**

EP 1 367 732 B1

- alternatively select soft symbol decisions/
soft bit decisions from every other stream
- can switch order of even/odd

SISO

output information bits

interleaver/
de-interleaver

reordered output
information bits

output
processor

de-coded data
(best estimates)

read block

- data *not* fed back to SISO
- no skip backs, data
supplied one time to output
processor

last iteration of SISO processing (embodiment using recycled SISO)

**Fig. 17**

EP 1 367 732 B1

| initial alpha check point value calculation (starting from block beginning) | initial beta check point value calculation (starting from block end) |
|---|---|
| for outer sub-blocks (from block beginning to block middle ), calculation of alphas and pushing check point values to check point stack | for outer sub-blocks (from block end to block middle), calculation of betas and pushing check point values to check point stack |

| for last sub-block adjacent to block middle, pushing each alpha value onto stack | for last sub-block adjacent to block middle, pushing each beta value onto stack |
|---|---|

| 1. calculation of alphas, pop betas from stack, and provide alphas and betas to calculate ext<br>2. re-calculation of alphas of appropriate preceding sub-block | 1. calculate betas, pop alphas from stack, and provide alphas and betas to calculate ext<br>2. re-calculate betas of appropriate preceding sub-block |
|---|---|

repeated until reach block ends

repeated until reach block ends

ext values calculation, 2 symbols at a time, starting from block middle towards block beginning and block end

SISO received block processing functionality

**Fig. 18**

input → alpha/beta metric calculation functional block 1

compensation for alpha/beta metric calculation 1 latency

alpha/beta stack(s) — logical stack 1 | logical stack 2

check point stack — push / pop

compensation for alpha/beta metric calculation 2 latency

alpha/beta metric calculation functional block 2

ext value and/or output value calculation → output

SISO functional block arrangement

**Fig. 19**

| FIFO |
| --- |
| (directs which interleave sequence applied to each bit lane, i0i1, of input symbol) |
| produces sequence for read operation |
| down counter (starts from center of block) |
| 2-1 MUX (decides whether to supply address for r/w) |
| s bus (RAMs into which actual interleave sequences are stored) |

| 3 RAMs - y | | | 3 RAMs - x | | |
| --- | --- | --- | --- | --- | --- |
| x2 | x1 | x0 | y2 | y1 | y0 |

| |
| --- |
| 3-1 MUXes (for each interleave sequence to be used for 1st & 2nd bit lane of i0i1) |
| latency block/flip flop (align data with its addresses from RAM) |
| adder (creates addresses for block ends) |
| DeMUXes (handshaking circuitry: provides registering/buffering so data sent out when needed, governs whether value permutated/non-permutated, supplies streams of addresses [4 address values, pre-fetched out of RAM], not timing dependent) |

block

time

accommodates skip backs when processing block

- 6 RAMs, partitioned x and y, can support 3 interleave sequences for 2 bit lanes simultaneously, i0i1 (may be scaled to include more/fewer; RAMs may be implemented as SRAMs)
- even/odd ping ponging
- pull addresses every other CLK cycle, can do pre-fetching allowing simultaneous r/w
- interleave: write permutated (folded), read sequentially
- de-interleave: write sequentially, read permutated

- data written to s bus RAM in folded manner; even to even locations/odd to odd locations

address generation for interleaver/de-interleaver functional block

**Fig. 20**

EP 1 367 732 B1

read block

write block

CLK cycle 1
(4 i/o operations: 2 r, 2 w)
(output 2 ext values per symbol)

CLK cycle 2
(4 i/o operations: 2 r, 2 w)
(output 2 ext values per symbol)

write occurs
after reaching
block middle
(2nd half of
processing)

logically partitioned RAM

| RAM bank 1 | RAM bank 2 |
|---|---|
| even i0 | even i0 |
| odd i1 | odd i1 |

logically partitioned RAM

| RAM bank 1 | RAM bank 2 |
|---|---|
| even i0 | even i0 |
| odd i1 | odd i1 |

data streams in
—i0→
—i1→

i0 w

i1 w

i0 r

i1 r

i0 r

i1 r

i0 w

i1 w

- even interleave placement
map to even locations in RAM
- odd interleave placement map
to odd locations in RAM

r/w swaps every
SISO operation

bit interleave/de-interleave functional block

## Fig. 21

EP 1 367 732 B1

counter usage within block processing (shown in 128 symbol sub-block embodiment)

**Fig. 22**

```
      ┌─────────────┐
      │    begin    │
      └─────────────┘
             │
             ▼
┌───────────────────────────────────────────────────────┐
│  starting from ends of block, process symbols to       │
│  calculate alphas and betas and store check point      │
│  values 2310                                           │
└───────────────────────────────────────────────────────┘
             │
             ▼
┌───────────────────────────────────────────────────────┐
│  within last sub-block before block middle, push       │
│  alpha and beta values onto stacks 2320                │
└───────────────────────────────────────────────────────┘
             │
             ▼
┌───────────────────────────────────────────────────────┐
│  perform sub-block skip-back processing towards        │
│  block edges, re-calculate alphas (and betas) using    │
│  stored check point values, and pop betas (and         │
│  alphas) from stacks 2330                              │
└───────────────────────────────────────────────────────┘
             │
             ▼
┌───────────────────────────────────────────────────────┐
│  calculate ext values using appropriate alphas and     │
│  betas for each symbol within block 2340               │
└───────────────────────────────────────────────────────┘
             │
             ▼
      ┌─────────────┐
      │     end     │
      └─────────────┘
```

received block processing method

## Fig. 23